(19) **Europäisches Patentamt**

**European Patent Office**

**Office européen des brevets**

(11) **EP 1 083 660 A1**

(12) **EUROPEAN PATENT APPLICATION**
published in accordance with Art. 158(3) EPC

(43) Date of publication:
**14.03.2001 Bulletin 2001/11**

(51) Int. Cl.⁷: **H03M 1/00**

(21) Application number: **00902875.4**

(86) International application number:
**PCT/JP00/00709**

(22) Date of filing: **09.02.2000**

(87) International publication number:
**WO 00/48323 (17.08.2000 Gazette 2000/33)**

(84) Designated Contracting States:
**AT BE CH CY DE DK ES FI FR GB GR IE IT LI LU MC NL PT SE**

(30) Priority: **09.02.1999 JP 3206699**

(71) Applicant: **Sony Corporation**
**Tokyo 141-0001 (JP)**

(72) Inventors:
• **IKEDA, Tamotsu,**
**Sony Corporation**
**Tokyo 141-0001 (JP)**

• **IKEDA, Yasunari,**
**Sony Corporation**
**Tokyo 141-0001 (JP)**
• **OKADA, Takahiro,**
**Sony Corporation**
**Tokyo 141-0001 (JP)**

(74) Representative:
**Robinson, Nigel Alexander Julian et al**
**D. Young & Co.,**
**21 New Fetter Lane**
**London EC4A 1DA (GB)**

(54) **DATA TRANSMISSION SYSTEM, DATA RECEIVER, AND DATA TRANSMITTING METHOD**

(57) To provide a receiving apparatus which can perform decoding according to the decoding capability of the receiving apparatus and a desired condition of a decoding signal, and a transmission apparatus for performing such error-correcting and coding processing. Error-correcting and coding means 11 of apparatus 1 applies predetermined error-correcting processing and predetermined coding processing to digital transfer data. An error may transfer data in a channel 3. According to the levels of error-correcting processing and decoding processing, decoding means 20 of a receiving apparatus 2 applies error-correcting processing and decoding processing to received data. It is preferred that the error-correcting and coding means 11 apply coding by the use of a systematic code as error-correcting processing and coding processing for which the decoding means 20 performs simple processing or can omit error-correcting processing and decoding processing, or apply coding by the use of an error-correcting code for which the decoding means 20 can control an error characteristic by the number of processing iterations, such as a product code, a concatenated code, or a turbo code.

FIG.1

**Description**

TECHNICAL FIELD

The present invention relates to a data transfer system having a data transmission apparatus and a data receiving apparatus, a data receiving apparatus, and a method therefor. More particularly, the present invention relates to a data transfer system, a data receiving apparatus, and a method therefor, which allow a video signal and/or an audio signal to be effectively transferred and to be decoded.

BACKGROUND ART

In data transfer field, especially in digital broadcasting field, a transmission apparatus encodes sources such as an image (video signal) and sound (audio signal) and other data, multiplexes these sources, applies channel coding, and sends the same to channel means such as an antenna or a wire channel. A receiving apparatus decodes and reproduces to obtain the sources by processing basically reverse to that performed by the transmission apparatus. In other words, the receiving apparatus performs channel decoding, demultiplexing, and source decoding.

The above-described digital data transfer system will be described below by referring to a specific example.

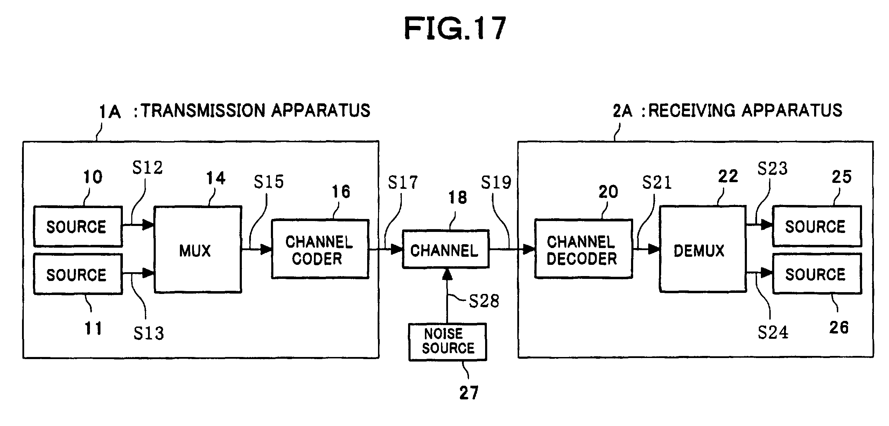

Figure 17 is a structural view of a basic digital-data transfer system. In this example, two types of sources, for example, a video signal and an audio signal will be described.

This digital-data transfer system includes a transmission apparatus (transmitter) 1A, a channel 18, and a receiving apparatus (receiver) 2A.

Various lines can be considered as channels 18. Channels 18 may be a wire channel, a radio channel, and an artificial satellite channel.

The transmission apparatus 1A includes a first source 10, a second source 11, a signal multiplexing unit (multiplexer: MUX) 14, a channel coder 16, and transmission means not shown. The receiving apparatus 2A includes receiving means not shown, a channel decoder 20, and a demultiplexer (DEMUX) 22. The demultiplexer 22 separates first source decoded data S25 and second source decoded data S26, and outputs them.

The transmission means and the receiving means which are not shown are determined according to the form of the channel 18. When the channel 18 is a radio communication cannel, for example, the transmission means includes an antenna and various-frequency conversion means for converting the output signal of the channel coder 16 to a high-frequency signal, and the receiving means has a receiving antenna for receiving the high frequency signal and various-frequency conversion means for lowering (reducing) a frequency of the high-frequency signal to a base band. When the channel 18 is a wire, the transmission means and the receiving means have structures appropriate for wire communication.

The operation of the transmission apparatus 1A will be described below. The first Source 10 inputs first digital source coded data S12, such as a video signal, to the signal multiplexing unit 14, and the second digital source 11 inputs second source coded data S13 related to the first digital source coded data S12, such as an audio signal related to the video signal, to the signal multiplexing unit 14.

The signal multiplexing unit 14 multiplexes the first digital source coded data (video signal) S12 and the second digital source coded data (audio signal) S13, by, for example, a time-division multiplexing method, and outputs a multiplexed digital signal S15.

The channel coder 16 performs error-correcting processing and digital modulation processing to the multiplexed digital signal S15. The processing performed by the channel coder 16 is called as a channel coding. Detailed contents of the channel coding will be described later. The channel coder 16 outputs a channel coded digital signal S17 and sends it to the channel 18 through the transmission means not shown.

When the channel 18 is a radio channel or an artificial-satellite channel, noise S28 caused by fading or multipation fading or sent from a noise source 27 may be superposed on the channel coded digital signal S17. Even if the noise S28 is superposed on the channel coded digital signal S17, the channel coder 16 in the transmission apparatus 1A adds an error-correcting code to the multiplexed digital signal S15 and the channel decoder 20, described later, performs error correction to the signal in order to increase reliability of decoding performed in the receiving apparatus 2A.

The operation of the receiving apparatus 2A will be described below.

Receiving means not shown receives a digital transmission signal S19 added the noise S28 to the channel coded digital signal S17, and inputs it to the channel decoder 20.

The channel decoder 20 performs the processing reverse to that performed by the channel coder 16, that is, demodulation (decoding) processing and error-correcting processing to the digital signal, and outputs a channel decoded result S21.

The demultiplexer 22 performs the processing reverse to that performed by the signal multiplexing unit 14 to the channel decoding result S21, for example, the demultiplexer 22 performs processing for separating a time-domain multiplexed signal along the time axis to separate into first demultiplexed digital data S23 and second demultiplexed digital data S24 and outputs them. The first demultiplexed data S23 corresponds to the first source coded data S12, for example, a video signal, and is decoded as the first source decoded data 25. In the same way, the second demultiplexed data S24 corresponds to the second source coded data S13, for example, an audio signal, and is decoded as the second source decoded data 26.

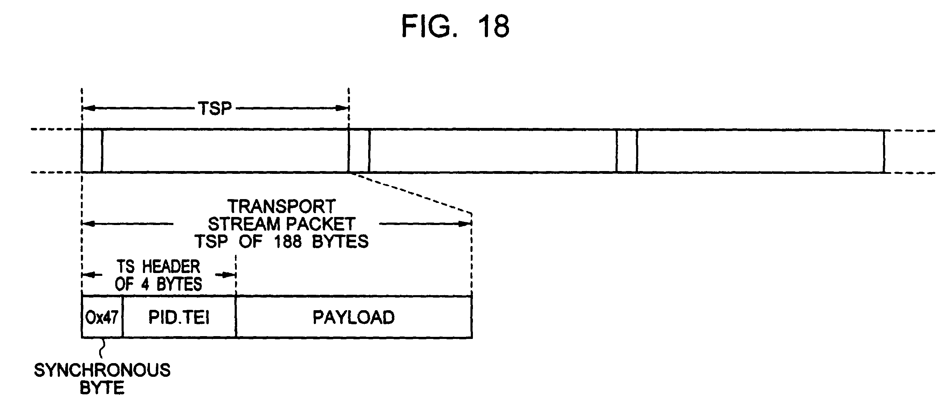

Figure 18 illustrates a transport stream TS of the MPEG-2 system (ITU-TH.220.0. ISO/IEC 13818-1).

When the data transferred in the above digital data transmission system is expressed by the MPEG-2 system, the multiplexed digital data 515 is output from the signal multiplexing apparatus in the transport stream TS form.

The transport stream TS is comprised of a plurality of transport streams packets (TSPs). One transport stream packet (TSP) is a 188-byte fixed-length packet formed of a four-byte transport stream header (hereinafter called a TS header) having a synchronization byte (0x47), and a 184-byte payload.

The TS header includes a packet identifier PID (packet ID) for identifying each packet.

The demultiplexer 22 in the receiving apparatus 2A separates the transport stream packet TSP into a first demultiplexed digital data S23 and a second demultiplexed digital data S24 with reference to packet identifiers PIDs respectively proper to the first source 10 and the second source 11 added in the signal multiplexer 14 in the transmitting apparatus 1A.

The TS header includes an error indication flag (transport-error indicator: TEI) . When the transport stream packet TSP includes an error, an error indication flag TEI is set to 1. When an error is not included, the error indication flag TEI is set to 0. Usually, the receiving apparatus 2A does not use the transport stream packet TSP having an error and discards such a transport stream packet TSP.

The demultiplexer 22 demultiplexes the channel decoded result S21 by referring to the packet identifier(PID). When the channel decoded result S21 decoded by the channel decoder 20 on which the noise S28 is superposed in the channel 18 has an error, the packet identifier PID may include an error, and the demultiplexer 22 may incorrectly demultiplex it. In this case, the demultiplexed data corresponding to the first demultiplexed data S23 (the first source decoded data S25) may lack the transport stream packet TSP, and the source decoding may be affected. When a video signal and an audio signal as the first source 10 and the second source 11, for example, are transferred through the channel 18, and when the noise S28 is superposed and an error is added to the packet identifier PID, an image or sound decoded (reproduced) by the receiving apparatus 2A is disturbed or intermitted.

When the data transfer is performed through the channel 18, in which the noise S28 may be superposed, an error control is necessary to remove an effect caused by the superposition of the noise S28 to allow the original data to be recovered as much as possible. In the data transfer system shown in Fig. 17, the error control is usually performed by the channel coder 16 and the channel decoder 20. Therefore, the channel coder 16 usually has an error-correcting-code adding processing section and a digital modulation section. The channel decoder 20 has a section for performing the precessing reverse to that performed by the channel coder 16.

Specific example circuit structures of the channel coder 16 and the channel decoder 20 will be described below.

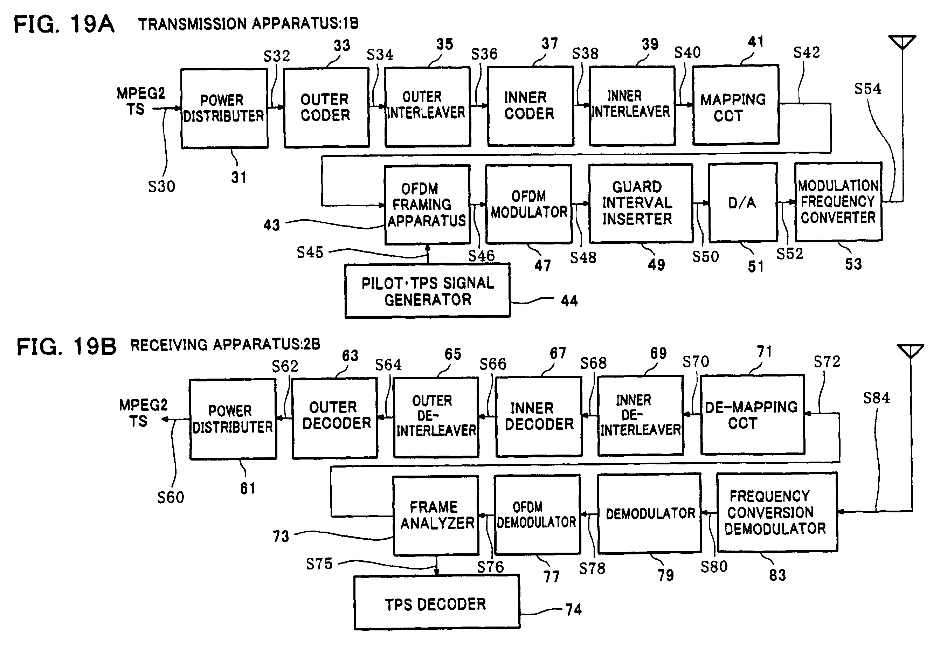

Figures 19A and 19B are views of a circuit structure of a digital data transfer system in an European digital terrestrial TV broadcasting system (DVB-T: ETS 300 744).

In the digital data transfer system, a TV-signal transmission apparatus (transmitter) 1B shown in Fig. 19A and a TV-signal receiving apparatus (receiver) 2B shown in Fig. 19B are connected through antennas.

In the system, where a video signal and an audio signal are transferred, an outer code and an inner code are used as error-correcting codes and an interleaving is performed between the outer code and the inner code for burst error spreading. In this example, a Reed-Solomon (RS) code is used as the outer code, a concatenated code using convolutional/punctured codes is used as the inner code under the condition that the receiving apparatus 2B uses Viterbi decoding, and an outer interleaving is performed between the outer code and the inner code for burst error spreading. As a modulation method, an OFDM (Orthogonal Frequency Dision Multiplexing) method is used. Frequency interleaving is performed between the inner code and OFDM.

The TV-signal transmission apparatus 1B includes a synchronization-byte-inversion and energy dispersal (distribution) unit 31, a Reed-Solomon coder 33 serving as an outer-code coder, an outer interleaver 35, a convolutional-code/punctured-code coder 37 serving as an inner-code coder, a frequency interleaver 39 serving as an inner interleaver, a signal-point mapping circuit 41, an OFDM framing unit 43, a pilot-signal and TPS-signal generation unit 44, an OFDM modulator 47, a guard Interval addition (inserting) unit 49, a digital-analog converter (D/A C) 51, and an orthogonal-modulation and frequency-conversion unit 53.

The TV-signal receiving apparatus 2B includes a frequency-conversion and orthogonal-demodulation unit 83, a demodulator 79, an OFDM demodulator 77, a transport-stream-packet (TSP) decoder 74, an OFDM frame analyzing unit 73, a signal-point de-mapping circuit 71, a frequency de-interleaver 69 serving as an inner de-interleaver, a convolutional-code/punctured-code decoder 67 serving as an inner-code decoder, a convolutional de-interleaver 65 serving as an outer de-interleaver, a Reed-Solomon-code decoder 63 serving as an outer-code decoder, and a synchronization-byte-inversion and energy dispersal (distribution) unit 61.

The operation of the TV-signal transmission apparatus 1B shown in Fig. 19A will be described below.

A transport stream (TSP) signal S30 obtained by coding a TV signal by the MPEG-2 method is input to the synchronization-byte-inversion and energy dispersal unit 31. The MPEG-2 transport stream (TS) signal S30 has a frame formed of eight transport stream packets TSPs.

The synchronization-byte-inversion and energy dispersal unit 31 inverts the synchronization byte "0x47" of the top transport stream packet TSP of a frame formed of eight transport stream packets (TSPs) to change it to "0xB8," applies energy distribution to the data of each transport stream packet TSP excluding the synchronization packet, by the use of a pseudo-random pulse train, and outputs an energy distribution processing result S32 to the Reed-Solomon coder 33.

The Reed-Solomon coder 33, which serves as an outer-code coder, encodes the energy distribution processing result S32 with the Reed-Solomon code RS (204, 188) (outer code) and outputs Reed-Solomon coded data S34 to the outer interleaver 35.

The outer interleaver 35 performs convolutional interleaving to the coded data S34 and outputs an obtained outer interleaving output S36 to the convolutional-code/punctured-code coder 27, in this example.

The convolutional-code/punctured code coder 37 is an coder for coding with the convolutional code/punctured code (inner code). It encodes the outer interleaving output S36 by the convolutional code/punctured code and outputs a result, a convolutional-code/punctured-code coded data S38, to the inner interleaver 39.

The inner interleaver 39 is a frequency interleaver 39 for frequency interleaving (inner interleaving). It performs frequency interleaving to the convolutional-code/punctured-code coded data S38 and outputs a result, an inner interleaving output S40, to the signal-point mapping circuit 41.

The signal-point mapping circuit 41 performs orthogonal coordinate mapping to the inner interleaving output S40 and outputs orthogonal coordinate mapping data S42 to the OFDM framing unit 43.

The pilot-signal and TPS-signal generation unit 44 generates a pilot signal and a TPS (Transfer Parameter Signal) signal S45.

The OFDM framing apparatus 43 multiplexes in frequency the orthogonal coordinate mapping data S42 and the pilot signal and the transport stream packet (TSP) signal S45 to form a frame user in the OFDM modulator 47 for OFDM modulation.

The OFDM modulator 47 performs OFDM modulation to OFDM framed data S46.

The guard interval addition unit 49 generates a guard interval period to which a part of the second half of OFDM modulated data S48 is copied, configures OFDM symbols disposed at the entire ODFM modulated data S48, and outputs OFDM symbol data S50 to which the guard interval is added, to the digital-analog converter (D/A C) 51.

The orthogonal-modulation and frequency-conversion unit 53, which serves as a front-end unit, applies orthogonal modulation and frequency conversion to a converted signal S52 which is converted to an analog signal by the D/A C 51, and emits it to the air through an antenna as a broadcasting wave S54.

The operation of the TV-signal receiving apparatus 2B shown in Fig. 19B will be described below.

The receiving apparatus 2B basically performs the operation reverse to that performed by the transmission apparatus 1B.

A received broadcasting wave S84 received by an antenna is frequency-converted and orthogonally demodulated by the frequency-conversion and orthogonal-demodulation unit 83, serving as a front-end unit, to generate an orthogonal-demodulated base-band signal S80. The signal is synchronized in various ways and is demodulated by the demodulator 79 to form a base-band OFDM signal S78. The signal is OFDM demodulated by the OFDM demodulator 77 to generate a demodulated data S76.

The OFDM frame analyzing unit 73 performs the processing reverse to that performed by the ODFM framing unit 43. In other words, the OFDM frame analyzing unit 73 generates OFDM decoded data S72 which can be de-mapped, from the demodulated data S76, and outputs the data S72 to the signal-point de-mapping circuit 71. The TSP decoder 74 decodes the OFDM decoded data S72 to obtain a TSP signal S75. The decoded TSP is used in subsequent signal processing.

The signal-point de-mapping circuit 71 performs the precessing reverse to that performed by the signal-point mapping circuit 41. The circuit 71 de-maps the OFDM decoded data S72 disposed on an orthogonal coordinate system to output a de-mapped signal S70.

The frequency de-interleaver 69, serving as an inner de-interleaver, performs the processing reverse to that performed by the frequency interleaver 39, that is, frequency de-interleaving, to the de-mapped signal S70.

The convolutional-code/punctured-code decoder 67, serving as an inner-code decoder, performs the processing reverse to that performed by the convolutional-code/punctured-code coder 37. In other words, the convolutional-code/punctured-code decoder 67 decodes a frequency de-interleaved signal S68 by the use of the convolutional code/punctured code, which is an inner code. A Viterbi decoder is usually used for this decoding.

The convolutional de-interleaver 65, serving as an outer de-interleaver, performs the processing reverse to that performed by the outer interleaver 35. In other words, the convolutional de-interleaver 65 convolutlonally de-interleaves a decoding result S66.

The Reed-Solomon decoder 63, serving as an outer-code decoder, performs the error-correction decoding on the de-interleaved signal S64 along the use of the RS (204, 188) as the outer code, and outputs an outer-code decoded signal S64.

The synchronization-byte-inversion and energy dispersal (distribution) unit 61 recovers a MPEG-2 transport stream (TS) signal S60 identical with the MPEG-2 transport stream S30, from the Reed-Solomon-decoded data S62.

The channel coding method described above by referring to Figs. 19A and 19B has been designed such that an error characteristic can be improved even in a poor condition such as frequency-selective fading and Rayleigh fading in the channel. If an error exceeding a designed value occurs, however, an image or sound of a TV signal is disturbed or intermitted.

Depending on a receiving mode at the receiving apparatus 2B, the above disturbance of a TV image or sound may be not a severe problem. But, if fading lasts for a long period of time, or a signal includes text data, since it is expected that a business party receives a large disadvantage, more powerful error-correcting processing may be demanded.

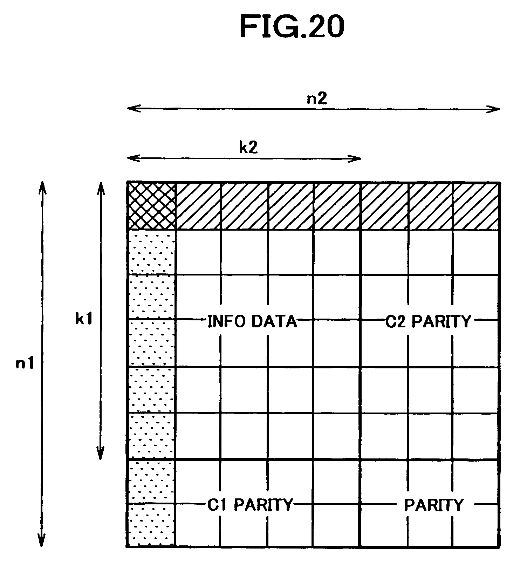

Figure 20 is a view showing an error-correcting method using a product code as such powerful error-correcting processing.

At a vertical portion shown by dots, a first error-correcting code (parity) C1 (n1, k1) is formed with an information symbol count of k1, a parity symbol count of (n1-k1), a code symbol count of n1 and a minimum distance of d1. At a horizontal hatched portion, a second error-correcting code (parity) C2 (n2, k2) is formed with an information symbol count of k2, a parity symbol count of (n2-k2), a code symbol count of n2, and a minimum distance of d2.

When both first error-correcting code C1 (n1, k1) and second error-correcting code C2 (n2, k2) are linear codes, any coding order can be used for the first error-correcting code C1 and the second error correcting code C2. The numbers of symbols for which errors can be corrected with the use of the first error correcting code C1 and the second error-correcting code C2 are $t1$ = an integer not exceeding $(d1 - 1)/2$ and $t2$ = an integer not exceeding $(d2 - 1)/2$, respectively. When a Reddy-Robinson decoding is performed for a product code, for example, it is known that the number of symbols for which errors can be corrected with the use of the C1 by C2 product code is $t0$ = an integer not exceeding $(d1 \times d2 - 1)/2$.

Since the product-code decoding described above by referring to Fig. 20 requires a lot of complicated processing and takes a Long period of time, it is impractical for media requesting real-time response, such as TV broadcasting. In addition, for a receiving apparatus driven by a battery, such as a portable receiving apparatus, since complicated, long-period processing needs high power consumption, it is impractical.

It is highly possible that a data error occurs when a channel characteristic is poor in data transfer. To solve this problem, when a transmission apparatus applies powerful error-correcting processing to data and sends the data to a channel, if a receiving apparatus performs decoding processing and error-correcting processing corresponding to the error-correcting processing which the transmission apparatus performs, since the error-correcting processing in the receiving apparatus needs many processes, the circuit structure of the receiving apparatus becomes complicated and power consumption increases. In addition, the decoding processing requires a long period of time. As a result, a quick response is not provided in a receiving form which requires a real-time ability. In addition, it is difficult for a simple receiver or an inexpensive receiver to implement such decoding processing in terms of a circuit scale and power consumption.

DISCLOSURE OF INVENTION

An object of the present intention to provide a data transfer system, a data receiving apparatus, and methods therefor to solve the above drawbacks.

The basic design of the present invention will be described below.

To solve the problem in which a data error occurs in data transfer when a channel characteristic is poor, in the present invention, a transmission apparatus applies powerful error-correcting processing (high-quality error-correcting processing) and a receiving apparatus performs appropriate error-correcting processing and decoding processing specified according to a receiving form, a processing capability, and other conditions imposed on the receiving apparatus.

When the receiving apparatus performs simple error-correcting processing and decoding processing, a quick decoding result is obtained, but the quality of the decoding result is low, and especially when an error is added in the channel, the decoding result may become poor. Even with such a low quality, however, a real-time capability or quickness is important in some cases. The cases include, for example, a compact, portable receiving apparatus.

On the other hand, when the receiving apparatus performs accurate error-correcting processing and decoding processing suited to the error-correcting processing performed by the transmission apparatus, even if an error is added in the channel, the original data is recovered accurately. However, a decoding time is long, the circuit structure of the receiving apparatus becomes complicated, and power consumption increases. Even with such inconveniences, however, a high-quality decoding result is required in some cases. The cases include, for example, a case when accurate recording is performed and a case when reproduction is performed with a fixed large TV receiver.

Some receiving apparatuses require both quickness and a high-quality decoding result. They are used, for example, in a case when, while a decoding result is observed in real time even if the result is low, an accurate decoding is recorded according to an observation result. In such a case, both simple error-correcting processing and decoding processing, and accurate error-correcting processing and decoding processing are necessary.

Therefore, a first object of the present invention is to provide a data receiving apparatus and a method therefor which allow appropriate error-correcting processing and decoding processing according to a requirement of the receiving apparatus when a transmission apparatus outputs a single transfer-line coded data.

Another object of the present invention is to provide an inexpensive receiving apparatus which satisfies the foregoing condition.

Still another object of the present invention is to provide a receiving apparatus which allows various types of decoding to be performed within a short period and which satisfies the foregoing condition.

A second object of the present invention is to provide a transfer system having the above transmission apparatus and the above receiving apparatus, and a data processing method including the above data transfer method and the data decoding method.

According to a first aspect of the present invention, there is provided a data transfer system comprising: a transmission apparatus including an coding means for performing a channel coding to a digital transfer data by using one step on plurality of steps of error correction code(s) which is obtained a first error characteristic when the digital transfer data is performed a channel decoding of a first decoding method at a receiving side; a channel means for transferring the channel coded data sent from said transmission apparatus; and a receiving apparatus including a decoding means for receiving the channel coded data transferred through the channel means; and performing a channel decoding the received channel coded data by using a second decoding method having an error characteristic lower than that of the first decoding method.

According to a second aspect of the present invention, there is provided a data transfer method including: an coding step for performing a channel coding to a digital transfer data by using one step on plurality of steps of error correction code(s) which is obtained a first error characteristic when the digital transfer data is performed a channel decoding of a first decoding method at a receiving side; a transmission step for transmitting the channel coded data produced at transmission step; a receiving step for receiving the channel coded data; and a decoding step for performing a channel decoding the received channel coded data by using a second decoding method having an error characteristic lower than that of the first decoding method.

According to a third aspect of the present invention, there is provided a data receiving apparatus receiving a channel coded data which is produced by performing a channel coding to a digital transfer data by using one step on plurality of steps of error correction code(s) which is obtained a first error characteristic when the digital transfer data is performed a channel decoding of a first decoding method at a receiving side, said data receiving apparatus comprises: a decoding means for performing a channel decoding the channel coded data by using a second decoding method having an error characteristic lower than that of the first decoding method.

BRIEF DESCRIPTION OF THE DRAWINGS

Figure 1 is a structural view of a data transfer system according to a first embodiment of the present invention.
Figure 2 is a structural view of a data transfer system according to a second embodiment of the present invention.
Figure 3 is a view showing the format of a transport stream packet (TSP), used for describing a systematic code in the first embodiment of the present invention.
Figure 4 is a structural view of the data transfer system according to the first embodiment of the present invention.
Figure 5 is a circuit-structural view of a simple decoder shown in Fig. 4.
Figure 6 is a view showing product-code coding processing in the second embodiment of the present invention.
Figure 7 is a structural view of the data transfer system according to the second embodiment of the present invention.
Figures 8A to 8E are graphs showing interleaving processing in the second embodiment of the present invention.
Figure 9 is a structural view of a data transfer system according to a third embodiment of the present invention.
Figure 10 is a circuit-structural view of first and second convolutional-code coders shown in Fig. 9.
Figure 11 is a circuit-structural view of the first and second coders shown in Fig. 9.
Figure 12 is a structural view of a data transfer system according to a fourth embodiment of the present invention.

Figure 13 is a circuit-structural view of a turbo code coder shown in Fig. 12.

Figure 14 is a circuit-structural view of a mapping decoder shown in Fig. 12.

Figure 15 is a structural view of a data transfer system according to a fifth embodiment of the present invention.

Figure 16 is a circuit-structural view of an interleaver shown in Fig. 15.

Figure 17 is a structural view of basic digital-data transfer system.

Figure 18 is a view showing the format of a transport stream in an MPEG-2 method (ITU-TH. 222.0, ISO/IEC 13818-1).

Figures 19A to 19B are circuit structures of a channel coder (transmission apparatus) and a channel decoder (receiving apparatus) in a European digital terrestrial TV broadcasting system (DVB-T: ETS 300 744).

Figure 20 is a view showing product-code processing.

## BEST MODE FOR CARRYING OUT THE INVENTION

A data transfer system, a data receiving apparatus, and a data transfer method according to embodiments of the present invention will be described below.

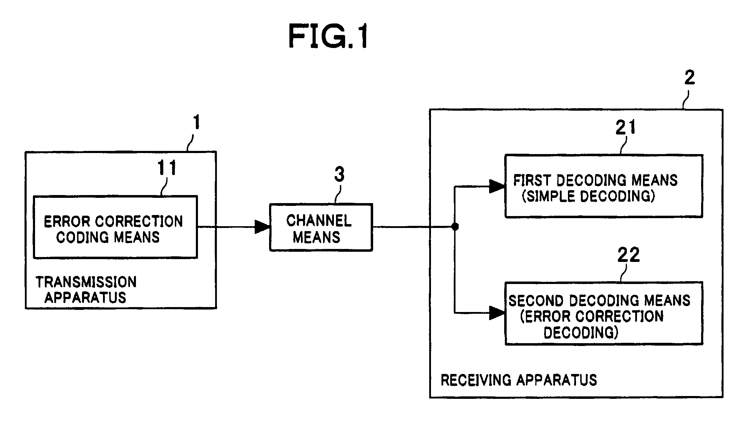

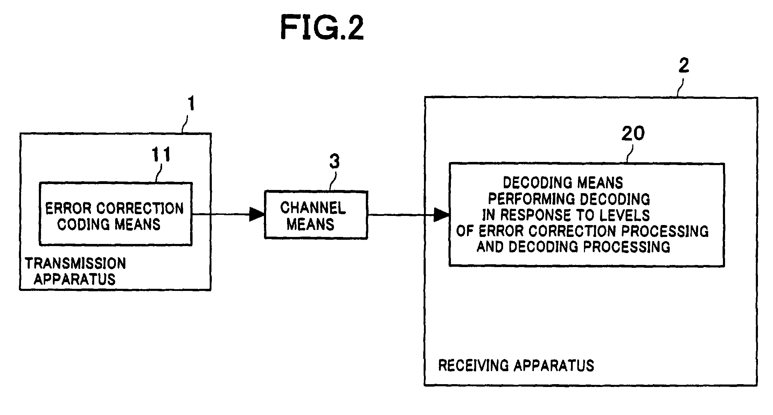

Coding processing and decoding processing used in an error-correcting and coding means 11 as a transfer-line coding means, and a decoding means 20 or a first decoding means 21 and/or a second decoding means 22 as a transfer-line decoding means, in the data transfer system shown in Fig. 1 and Fig. 2, will be described below. In the error-correcting and coding means 11, to realize a desired reception, the coding processing is performed by using:

(1) an error correction code which allows the omission of the reversing operation in the reception side, such as a systematic code, (2) an error correction code which can control an error characteristic by repeating the error correction in the reception side, i.e., a product code, a concatenated code and a turbo code, (3) an error correction code which can control an error characteristic by a size of a processing circuit in the reception side, i.e., a convolution code/punctured code or a turbo code, and (4) an error correction code combined codes of (1) to (3). The decoding means 20 or the first decoding means 21 realizes a desired reception by omitting the reverse processing for an error correction or by performing a simple processing. Detailed embodiments will be described.

### First Embodiment

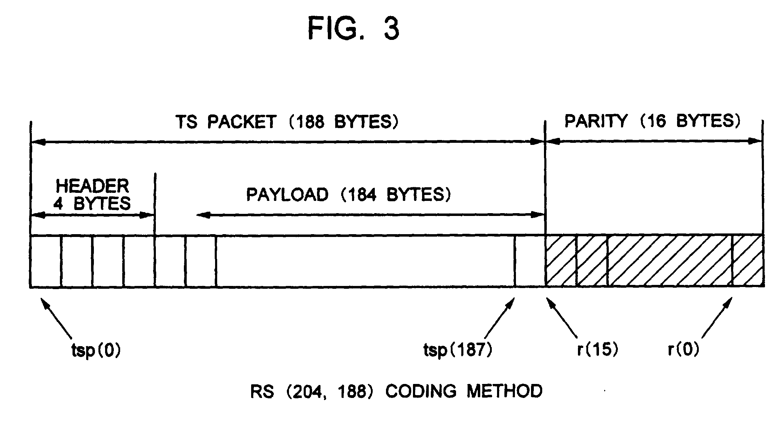

Figure 3 is a view showing a format of a transport stream packet TSP to which the Reed-Solomon code RS (204, 188) is applied as a simplified processing of coding processing and simplified decoding processing for the systematic code in a present embodiment.

As described above by referring to Fig. 18, a transport stream TS is formed of a plurality of transport stream packets TSPs.

In the data transfer system shown in Fig. 1 and Fig. 2, data transferred through the channel means 3 such as a radio channel is configured in the format of transport stream packets TSPs. A case in which the Reed-Solomon code RS (204, 188) is used as a systematic code will be described below.

A transport stream packet TSP of the Reed-Solomon code RS (204, 188) is defined as a 188-order vector in a Galois field GF ($2^8$) space indicated below by the following formulas (1) and (2).

$$M(x) = (tsp(0), tsp(1),..., tsp(187)) \tag{1}$$

$$= tsp(0)x^{187} + tsp(1)x^{186} + ... + tsp(187)x^{0} \tag{2}$$

The following formula (3) indicates a primitive polynomial on the Galois field GF ($2^8$).

$$p(x) = x^8 + x^4 + x^3 + x^2 + I \tag{3}$$

The following formula (4) indicates a generator polynomial, where "a" indicates 0x02.

$$g(x) = (x - a^{o})(x - a^{1})(x - a^{2})...(x - a^{15}) \tag{4}$$

An coding method using the Reed-Solomon code RS (204,188) as a systematic code will be described next.

M(x) is multiplied by $x^{16}$, and the resultant product is divided by g(x). The remainder is called as R(x). The following formula (5) indicates this calculation. The remainder R(x) can be expressed by the following formulas (5) to (7).

$$R(x) = M(x)x^{16} mod g(x) \tag{5}$$

$$= r(15)x^{15} + r(14)x^{14} + ... + r(0)x^{0} \qquad (6)$$

$$= (r(15), r(14), ... , r(0)) \qquad (7)$$

As a result of the above calculation, a 16-Order vector is obtained as the remainder R(x).

With the use of the foregoing result, the codeword of the Reed-Solomon code RS(204) is a 204-order vector expressed by the following formulas (8) and (9).

$$C(x) = M(x)x^{16} - R(x) \qquad (8)$$

$$= (tsp(0), tsp(1), ...,tsp(187), r(15), r(14), ..., r(O)) \qquad (9)$$

The code C(x), as shown in Fig. 3, has a form of (M, -R) in which an information vector M(x) is concatenated with a parity (-R(x)) and is called "a systematic code". This systematic code is the same as the Reed-Solomon code RS (204, 188) used as an outer code in DVB-T described above by referring to Figs. 19A and 19B. In other words, the Reed-Solomon code RS (204, 188) is one of systematic codes.

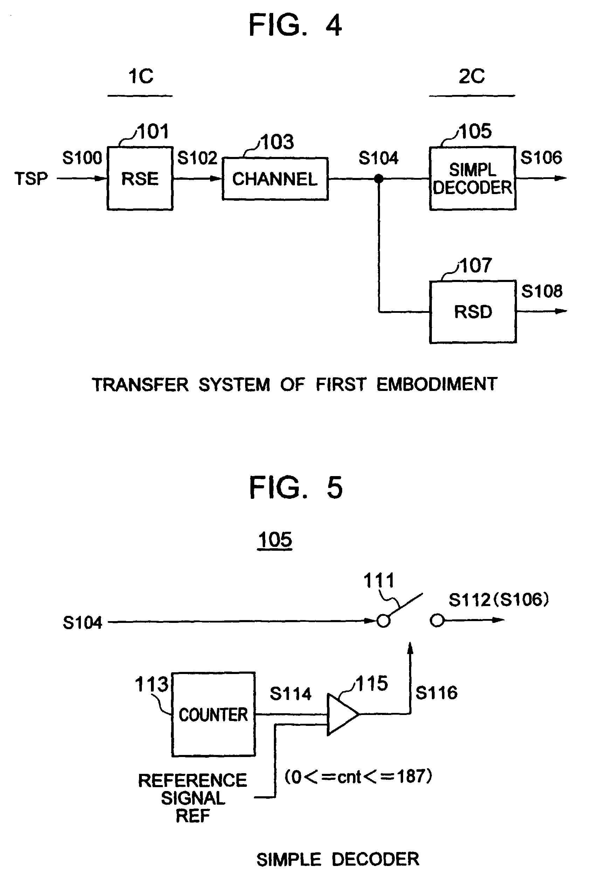

Figure 4 is an outlined structural view of a data transfer system according to a first embodiment of the present invention. In the structure shown in Fig. 4, a portion irrelevant to a transmission apparatus 1C and a receiving apparatus 2C of the present invention is omitted.

The data transfer system shown in Fig. 4 is used for transferring a video signal, an audio signal, and others of the TV broadcasting described by referring to Figs. 19A and 19B. Hereinafter, a video signal and an audio signal are taken as examples of transfer data.

In the data transfer system shown in Fig. 4, a Reed-Solomon coder 101 serving as an embodiment of the error-correcting and coding means 11 of the transmission apparatus 1 shown in Fig. 1 and Fig. 2 encodes a transport stream packet (TSP) S1OO by a Reed-Solomon code RS (204,188) to form coded data S102 and transfers it through a channel 103 serving as the channel means 3 shown in Fig. 1, and a simple decoder 105 serving as an embodiment of the first decoding means 21 of the transmission apparatus 2 shown in Fig. 2 and a regular decoder 107 serving as an embodiment of the second decoding means 22 decode the data to reproduce the transport stream packet TSP.

The RS (204, 188) coder 101 encodes the transport stream packet (TSP) S1OO with a systematic code by the method described above by referring to the formulas (1) to (9). The Reed-Solomon coded signal S102 coded by the RS (204, 188) coder 101 is transferred through the channel 103. In the channel 103, an error may be added to the signal by frequency-selective fading, multipath fading, and other noise.

Transmission data S104 to which an error is added in the channel 103 is decoded by the simple decoder 105 and the regular decoder 107 in the receiving apparatus. The simple decoder 105 outputs simple-decoded data S106, and the regular decoder 107 outputs regular decoded data S108.

Note, the receiving apparatus is not needed the both simple decoder 105 and the regular decoder 107, and thus, depending upon the required reception mode and/or the required error characteristic, the receiving apparatus may include only the simple decoder 105 or only the regular decoder 107.

The simple decoder 105 is formed, for example, of a switch 111, a counter 113, and a comparator 115 as shown in Fig. 5.

The counter 113 is reset in synchronization with the top byte of the Reed-Solomon code RS shown in rig. 3, and incremented by one every time one byte of a Reed-Solomon code is input. In other words, the counter 113 counts the number of bytes in received data S104.

The comparator 115 refers a reference signal REF; and outputs a comparison-result signal S116 of a high level "H" (1) when the count of the counter 113 falls in a range from 0 to 187, in other words, when the received data S104 has the number of bytes corresponding to the transport stream packet (TSP) data, and outputs a comparison-result signal S116 of a low level "L" (1) not satisfied.

The switch 111 is closed when the comparison-result signal S116 is "1" (high level, "H") and is opened when the comparison-result signal S116 is "0" (low level, "L"). While the switch 111 is closed, the received data S104 is output as is, and while the switch 111 is opened, no data is output. Therefore, the switch 111 outputs a transport stream packet (TSP) of 0 to 187 bytes and does not output a parity thereafter. An output S112 of the switch 111 corresponds only to the transport stream packet (TSP) in the received data S104.

In this way, the simple decoder 105 detects only 188-byte data starting from the top of the 204-order, that is, 204-byte received codeword vector by the counter 113 and the comparator 115, and extracts it by driving the switch 111 to decode it. As shown in Fig. 3, 188 bytes starting from the top of the systematic-code-coded (Reed-Solomon-code-coded), received data is input data itself, namely, a systematic component and the following 16 bytes are parity data, and thus this decoding processing can be realized. Such an output signal is a simple decoding result in which error-correction or decoding is substantially not performed.

The above-described simple decoder 105 cannot correct an error added in the channel 103. As described in Fig. 5, however, it is advantageous that the circuit structure is very simple, the decoding method is very simple, and a decoding result is quickly obtained. Such a decoding method in which only an effective portion of data is extracted has a great effect when quick decoding (reproduction) is necessary, when noise superposed in the channel is very low and an error is very small, when an error is allowed to some extent, and when a compact, low-power-consumption receiving apparatus is required.

The regular decoder 107 corresponding to the second decoding means 22 shown in Fig. 2 performs error correction by using a Euclid method as an error-correcting processing in accordance with the RS (204, 188) coding, when regular decoding is performed with the use of a Reed-Solomon code, an error up to eight bytes are completely corrected. As compared with the simple decoder 105, the regular decoder 107 has a large circuit scale and needs a long decoding period of time.

As a mode of use of the simple decoder 105 and the regular decoder 107, when a decoding result of the simple decoder 105 is used, for example, such as in a which a video signal and an audio signal of TV broadcasting are viewed in real time, if the user wants to record a program, the user sends a recording instruction to the receiving apparatus 2C to record a result of accurate decoding performed in the regular decoder 107 into a recording medium. It is preferred that a decoding result of the regular decoder 107 be used when an accurate decoding result is required whereas real-time recording is not requested.

Second embodiment

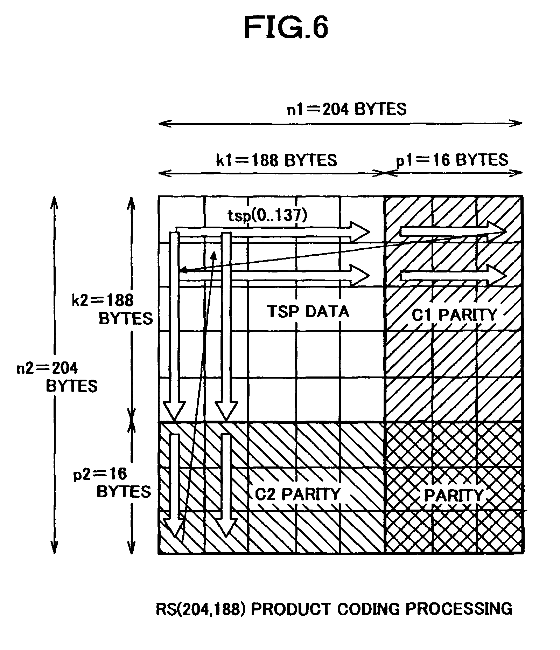

A second embodiment related to coding with a product code by the use of systematic codes and simplified decoding processing will be described below by referring to Fig. 6.

Figure 6 is a view showing a case in which a Reed-Solomon (RS) (204, 188) product code is used as a product code formed of systematic codes. An coding method for a product code will be described below.

As shown by white arrows in the horizontal direction in Fig. 6, a 188-byte transport stream packet TSP serves as information data of a first RS code C1 (n1, k1).

(1) The 188-byte TSP is first coded by the use of the RS code C1. Specifically, a "p1" (=16-byte) parity is generated and added to "k1" (=188 byte) information bytes to form a "n1" (= 204 byte) codeword of the first RS code C1. The method described in the above first embodiment can be used as an RS-coding method.
(2) Only 188 bytes of the above codeword of the RS code C1 are coded by the use of an RS code C2. Specifically, a "p2" (16-byte) parity is generated and added to "k2" (=188 byte) information bytes in the vertical direction to form a "n2" (= 204 byte) codeword of the second RS code C2 (as indicated by vertical hatched arrows).

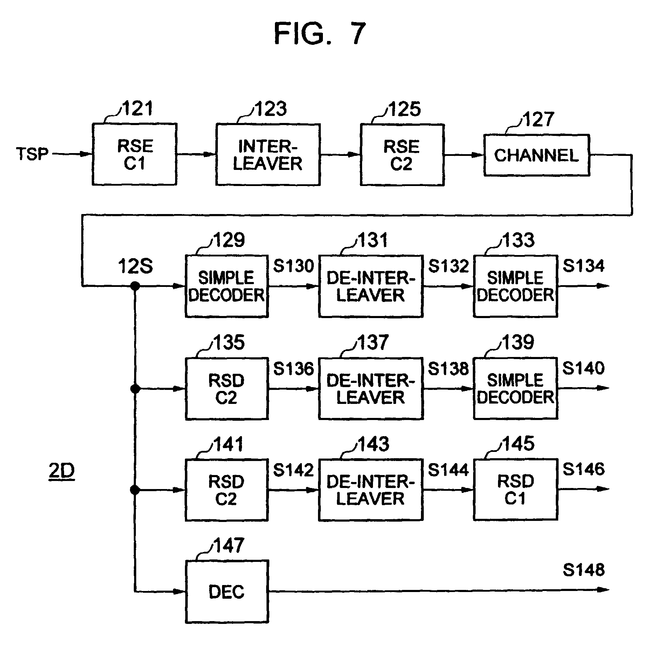

Figure 7 is a structural view of a data transfer system according to the second embodiment.

A transmission apparatus 1D shown in Fig. 7 includes a first Reed-Solomon coding unit 121, an interleaver 123, and a second Reed-Solomon coding unit 125. The transmission apparatus 1D performs the above-described systematic-code coding processing.

The first Reed-Solomon coding unit 121 performs RS (204, 188) coding processing to a transport stream packet (TSP) serving as an input signal to encode in the horizontal direction with the use of the first RS code C1 (n1, k1) for first systematic-code coding processing.

The interleaving means 123 is an interleaver formed of a two-dimensional memory of 204 horizontal bytes by 188 vertical bytes. It writes data S123 coded by the use of the first RS code C1 (n1, k1) into the interleaver memory in the horizontal direction, and reads 204 data items in the vertical direction when 188 coded data items have been written.

The second Reed-Solomon coding unit 125 performs RS (204, 188) coding processing to an interleaved signal to encode in the vertical direction with the use of the second RS code C2 (n2, k2) for second systematic-code coding processing. With the above operations, the transport stream packet (TSP) is coded by the RS (204, 188) product code shown in Fig. 6 in the transmission apparatus 1D.

Product-code coded data generated in the transmission apparatus 1D as described above is transferred through a channel 127 and received by a receiving apparatus 2D.

An error may be added to transfer data S126 by noise in the channel 127.

In the present embodiment, the receiving apparatus 2D performs decoding by a four-steps method to reproduce the transport stream packet TSP. Therefore, the receiving apparatus 2D has four decoding circuits.

First decoding circuit

A first decoding circuit includes a first simple decoder 129, a de-interleaver 131, and a second simple decoder 133, and performs simple decoding.

The first simple decoder 129 has, for example, the same circuit structure as that shown in Fig. 5, and extracts only an effective portion (transport stream packet (TSP)) from the data disposed in the vertical direction in Fig. 6 as decoding data.

The de-interleaver 131 is an interleaver formed of a two-dimensional memory of 204 horizontal bytes by 188 vertical bytes. It writes a data output S130 decoded by a simple method in the vertical direction into a de-interleaver memory in the vertical direction, and reads 188 data items from the memory in the horizontal and vertical directions when 204 decoded data items have been written.

The second simple decoder 133 has, for example, the same circuit structure as that shown in Fig. 5, and extracts only an effective portion (transport stream packet (TSP)) from the data disposed in the horizontal direction in Fig. 6 as decoding data.

The transmission apparatus 1D performs product-code coding processing, and, the above-described first decoding section picks up the substantial systematic component, but does not perform error-correcting processing with the use of the parities C1 and C2 shown in Fig. 6. In this regard, decoded data has a low reliability. In the first decoding section, however, processing at the simple decoders 129 and 133 is very fast, and processing at the de-interleaver 131 is also fast since it is reading and writing from and into a memory. Therefore, decoding processing in the first decoding circuit is fast and real time. The circuit structure of the first decoding circuit is also very simple.

Second decoding circuit

A second decoding circuit includes a Reed-Solomon decoding section 135, a de-interleaver 137, and a simple decoder 139, and performs more accurate decoding than the first decoding section.

The Reed-Solomon decoding section 135 applies decoding by the use of a second Reed-Solomon code, RS (188, 204), in the vertical direction of received data S128 by a Peterson method or an Euclidean method.

The de-interleaver 137 has the same circuit structure as the de-interleaver 131. It writes a data output S136 decoded by the Reed-Solomon decoding section 135 in the vertical direction into a de-interleaver memory in the vertical direction, and reads 188 data items from the memory in the horizontal and vertical directions when 204 decoded data items have been written.

The simple decoder 133 has the same circuit structure as the second simple decoder 133 shown in Fig. 5, and extracts only an effective portion (transport stream packet (TSP)) from the data disposed in the horizontal direction in Fig. 6 as decoding data.

Since the Reed-Solomon decoding section 135 performs second Reed-Solomon decoding in the second decoding circuit, the second decoding circuit has a higher error-correcting capability than the first decoding circuit. The Reed-Solomon decoding section 135, however. has a more complicated circuit structure than the first simple decoder 129 in the first decoding circuit, and needs a longer processing period of time. Since the simple decoding section 139 performs decoding by a simple method in which error correction is not performed, in the same way as in the second simple decoder 133, a decoding speed is high.

Third decoding circuit

A third decoding circuit includes a first Reed-Solomon decoding section 141, a de-interleaver 143, and a second Reed-Solomon decoding section 145, and performs regular decoding with the Reed-Solomon code.

The first Reed-Solomon decoding section 141 has the same circuit structure as the Reed-Solomon decoding section 135, and applies decoding by the use of the second Reed-Solomon code, RS (188, 204), in the vertical direction of the received data S128 by the same method as that used by the Reed-Solomon decoding section 135.

The de-interleaver 143 has the same circuit structure as the de-interleavers 131 and 137. It writes a data output S142 decoded by the first Reed-Solomon decoding section 141 in the vertical direction into a de-interleaver memory in the vertical direction, and reads 188 data items from the memory in the horizontal direction when 204 decoded data items have been written.

The second Reed-Solomon decoding section 145 performs decoding by the use of the second Reed-Solomon code, RS (188, 204), in the vertical direction of the received data S128 by the above-described method with the Reed-Solomon code. As a method for decoding the first Reed-Solomon code, for example, the second Reed-Solomon decoding section 145 uses a decoding method in which error correction including a erasure correction is possible, to perform erasure correction with the use of information of an error-correcting result of the first Read-Solomon decoder 141.

Note, a iterative decoding which decodes again the decoded result of the second Read-Solomon decoder 145 by the first Read-Solomon decoder 141.

Since decoding is performed together with error-correcting processing with the Reed-Solomon code, which has a high error-correcting capability, in the third decoding circuit, even if an error caused by noise is added to transfer data in the channel 127, the original data, the transport stream packet TSP, is accurately recovered. In other words, the third decoding circuit recovers the original transport stream packet (TSP) more accurately than the second decoding circuit. The processing time of the third decoding circuit is, however, longer than those of the first decoding circuit and the second decoding circuit described above.

Fourth decoding circuit

A fourth decoding circuit is formed of a product-code decoding unit 147.

A minimum-distance decoding method, the Reddy-Robinson decoding method, or others can be used as a decoding method in the product-code decoding unit 147.

The fourth decoding circuit performs higher-quality error correction than the first to third decoding circuits described above. Its processing time is, however, longer that those of the first to third decoding circuits described above.

It is obvious that the receiving apparatus 2D according to the second embodiment does not need to have all of the four decoding circuits. According to a required level of an error-correcting capability in a decoding signal and the price of the receiving apparatus, single or any combinations can be selected.

Other product-code forms

The RS (204, 188) product code has been described as an example. When a primitive polynomial p(x) constituting a code and a generator polynomial g(x) of the code are the same Reed-Solomon code RS, it is easy to share a decoding apparatus. In Reed-Solomon coding processing, the number of information bytes can be selected from 1 to 239 (= 255 - 16). An interleaver corresponding to the code length of Reed Solomon-code coded data needs to be used.

Modification of interleaver

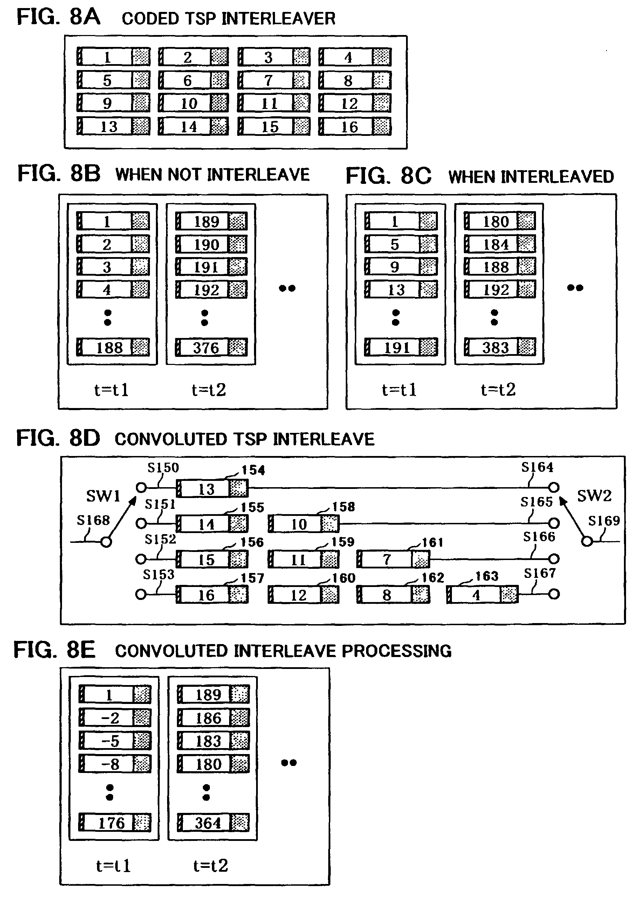

Figs. 8A to 8E show other processing methods for the interleaver 123.

RS coded data C1 obtained by coding input transport stream packets (TSP) in the first Reed-Solomon coding unit 121 shown in Fig. 7 is arranged in the order of time of coded TSPs, and symbols are assigned as shown in Fig. 8A as TSPI and TSP2.

The operation of the interleaver 123 shown in Fig. 7 will be described below. The interleaver 123 rearranges in the order of TSP1, TSP2, ..., TSP188, as shown in Fig. 8B. Then, in the second Reed-Solomon decoding unit 125, the RS code C2 coder 125 applies coding in the vertical direction in Fig. 8B.

In the present embodiment, output TSP packets such as TSP1 and TSP2 are stored in an interleaving memory which can store four by four TSPs as shown in Fig. 8A in the horizontal direction in Fig. 8A; when they have been stored in the interleave memory, the TSPs are read in the vertical direction in Fig. 8A in units of TSPs and re-arranged in the order of TSP1, TSP5, ..., TSP189 as shown in Fig. 8C; and they are coded in the vertical direction in Fig. 8C with the use of the RS code C2 by the second Reed-Solomon coding unit 125.

The size of the interleaving memory shown in Fig. 8A is not limited to four by four. It can be actually set to an appropriate size corresponding to the channel such that the system works irrespective of a radio-wave interruption and a spontaneous signal stop which can happen during transfer.

The interleave method shown in Fig. 8A is generally called a block interleave. A convolutional interleave method, shown in Fig. 8D, may be used.

Figure 8D shows a convolutional interleaver having a interleaving depth of four and a size in which coded TSPs can be stored in one memory block.

The structure of the interleaver 123 will be described below. Switches 168 and 169 switch branches in synchronization with TSPs. Inputs 150 to 153 are input to branches of the convolutional interleaver. Memories 154 to 163 store transport stream packets (TSPs). Outputs 164 to 167 are output from the branches of the convolutional interleaver.

The operation of the convolutional, interleaving shown in Fig. 8D will be described below. When TSPs are input to the interleaver 123 in which TSP1, TSP2, and others are coded, the first switch 168 cyclically switches a branch to be connected, in synchronization with the inputs in the order of the branch input sections 150, 151, 152, 153, 150, .... An n-th input transport stream packet TSPn is stored in a first-stage memory for an coded TSP, a TSPm stored in the memory is shifted to the next-stage memory if the corresponding branch has the next-stage memory for an coded TSP, a data shift is caused in the same way for each branch, data is output from the branch outputs 164 to 167, and an interleaver output is obtained by the second switch 169 which performs a switching operation in synchronization with that of the first switch 168 at the input side.

Figure 8D shows a case in which TSPs are input up to TSP 16. This interleaver re-arranges inputs of TSP-2, TSP-1, TSP0, TSP1, TSP2, and others in the order of TSP1, TSP-2, TSP-5, TSP-8, TSP5, TSP2, TSP-1, TSP-4, ..., and TSP176. The coder 125 for the RS code C2 applies coding to the TSPs in the vertical direction in Fig. 8E.

Third embodiment

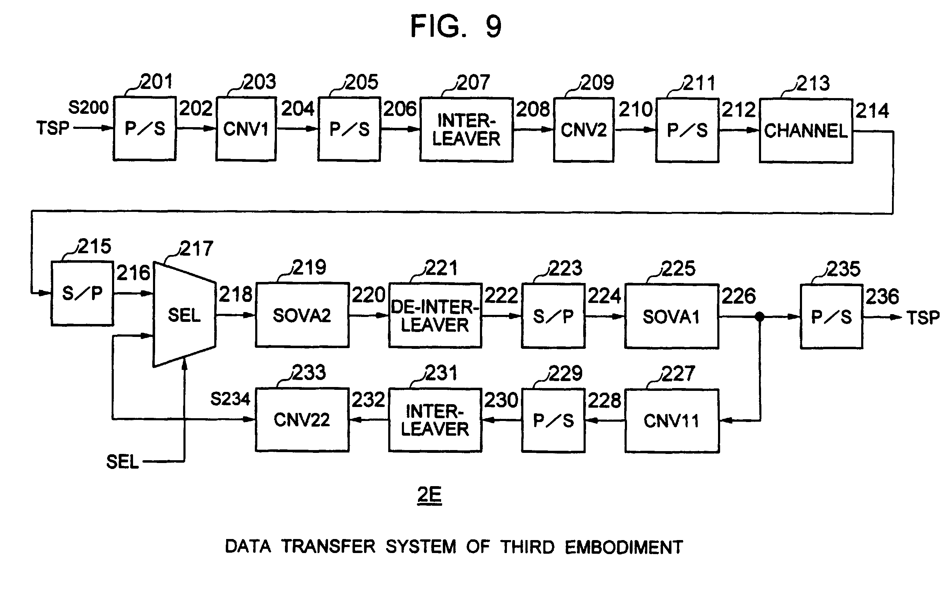

Figure 9 shows a circuit structure of a data transfer system according to a third embodiment of the present invention, which performs coding by the use of a concatenated code of convolutional codes and simplified decoding processing.

In the third embodiment, a transport stream packet (TSP) is input, coding is performed by the use of a concatenated code formed of a first convolutional code CC1 (coding rate $R1 = k1/n1$ ) and a second convolutional code CC2 (coding rate $R2 = k2/n2$ ), and decoding processing is simplified.

The data transfer system shown in Fig. 9 includes a transmission apparatus 1E, a channel 213, and a receiving apparatus 2E.

The transmission apparatus 1E includes a first parallel-serial converter 201, a first convolutional-code coder 204, a second parallel-serial converter 205, an interleaver 207, a second convolutional-code coder 209, and a third parallel-serial converter 211.

The first parallel-serial converter 201 converts an eight-bit parallel transport stream packet (TSP) serving as an input signal S200 to k1-bit data.

The first convolutional-code coder 203 receives a converted k1-bit serial data S202, applies first convolutional-code CC1 (coding rate $R1 = k1/n1$ ) processing thereto, and outputs an n1-bit convolutional-code coded signal S204.

The second parallel-serial converter 205 converts n1-bit data to k2-bit data.

The interleaver 207 arranges the input order of k2-bit, converted, convolutional-code coded data S206 according to a predetermined rule to obtain a k2-bit output sequence.

The second convolutional-code coder 209 applies second convolutional-code CC2 (coding rate $R2 = k2/n2$ ) processing to k2-bit, interleaved, output-sequence data S208, and outputs an n2-bit convolutional-code coded signal S210.

The third parallel-serial converter 211 converts n2-bit data to one-bit data.

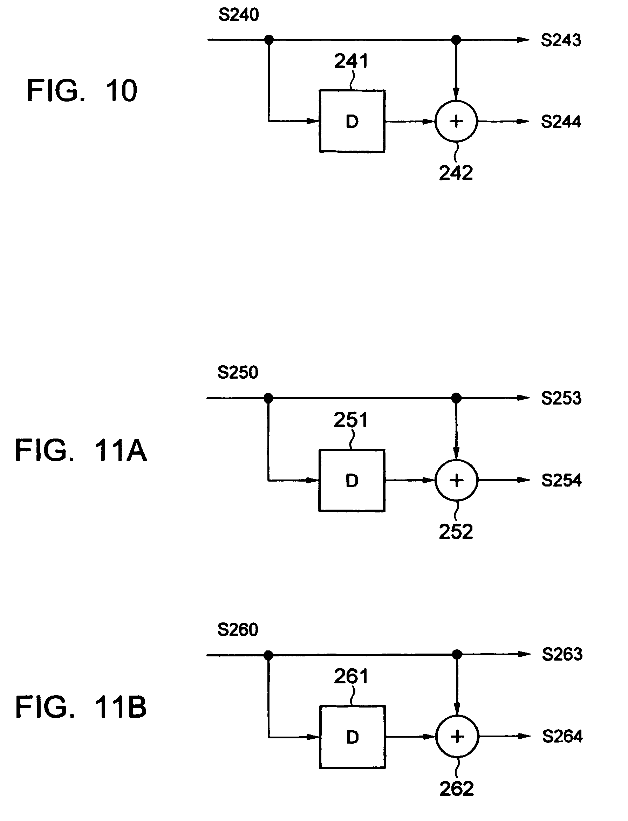

Figure 10 shows an example structure of the first convolutional-code coder 203 and the second convolutional-code coder 209.

The example structure of the convolutional-code coders shown in Fig. 10 indicates a case in which CC1 and CC2 are set such that R1 and R2 equal ½.

This convolutional-code coder is formed of a unit-delay circuit 241 and an exclusive-OR circuit 242.

The unit-delay circuit 241 delays one-bit input data S240 by a unit period of time, and the exclusive-OR circuit 242 calculates exclusive OR of a unit-delayed signal and the input data. Therefore, a first output signal S243 is the same as the input signal, and a second output signal S244 is an exclusive-ORed signal of the unit-delayed signal and the input data.

The channel 213 shown in Fig. 9 includes a channel coding apparatus, a channel, and a channel decoding apparatus. When data is transferred through the channel, an error is added by noise.

The receiving apparatus 2E shown in Fig. 9 includes a first serial-parallel converter 215, a selector 217, a first decoder 219, a de-interleaver 221, a second serial-parallel converter 223, a second decoder 225, a first re-coder 227, a parallel-serial converter 229, an interleaver 231, a second re-coder 233, and a third serial-parallel converter 235.

Transfer data S214 sent from the channel 213 is converted from one-bit data to n2-bit parallel data by the first serial-parallel converter 215.

The selector 217 selects converted data S216 output from the first serial-parallel converter 215 or a re-coded data S244 output from the second re-coder 233. Specifically, the selector 217 selects the output signal S216 of the serial-parallel converter 215 as an selection output S218 when the subsequent-stage circuits 219, 221, 223, and 225 processes a received signal, and selects the output signal S234 of the second re coder 233 as the selection output 218 when the subsequent-stage circuits 219, 221, 223, and 225 processes data for repeated processing, according to a selection control signal SEL sent from a control circuit not shown.

The first decoder 219 applies soft-decision decoding to the second convolutional code CC2 (coding rate $R2 = k2/n2$ ) processed by the second convolutional-code coder 209, by the use of the input signal S218 and the reliability information of the input signal, and outputs a k2-bit decoding result and the reliability information of the output. A signal S220 indicates the k2-bit decoding result of CC2, and n2-bit reliability information of the decoding result.

The first decoder 219, which applies soft-decision decoding to the second convolutional code CC2 and outputs the decoding result and the reliability information of the output, can be configured with the use of a Viterbi algorithm or a soft output Viterbi algorithm (SOVA). The output data and the reliability information thereof are obtained.

The de-interleaver 221 changes the sequence order of the signal S220 according to the rule reverse to that for the interleaving in the interleaver 207.

The second serial-parallel, converter 223 converts a signal formed of a de-interleaved k2-bit decoding result and a de-interleaved n2-bit reliability information to a k1-bit decoding result and n1-bit reliability information.

The second decoder 225 performs soft-decision decoding to the first convolutional code CC1 (coding rate R1 = k1/n1 ) processed by the first convolutional-code coder 203, by the use of an input signal S224 and the reliability information of the input signal, and outputs a k1-bit decoding result and the reliability information of the output. A signal S226 indicates the k1-bit decoding result of CC1, and n1-bit reliability information of the decoding result. The signal S226 includes the k1-bit CC1. decoding result and the n1-bit reliability information of the decoding result.

The second decoder 225 which applies soft decision decoding to the first convolutional code CC1 and outputs the decoding result and the reliability information of the output, can be configured with the use of the Viterbi algorithm or the soft-output Viterbi algorithm in the same way as for the first decoder 219. The output data and the reliability information thereof are obtained.

To sufficiently perform error-correcting processing, iteration processing described below is performed the required number of times. When the number of times the iteration processing is performed is increased, an error-correcting capability is improved. In other words, the receiving apparatus 2E shown in Fig. 9 has a structure which allows both simple error-correcting processing and decoding, and complicated error-correcting processing and decoding. It is a matter of course, however, that complicated error-correcting processing and decoding processing requires a long decoding-processing period of time.

The operation of a recursive circuit for repetitive operation, formed of the first re-coder 227, the parallel-serial converter 229, the interleaver 231, and the second re-coder 233 will be described below.

The first re-coder 227 uses the signal S226 formed of the k1-bit CC1 decoding result and the n1-bit reliability information of the decoding result output from the second decoder 225 to perform re coding of CC1, obtains n1-bit coded data, and generates the reliability information of the coded data by the use of the reliability information included in the signal S226. A signal S228 indicates n1-bit CC1-re-coded data and the reliability information thereof.

The parallel-serial converter 229 converts the n1-bit CC1-re-coded data and the reliability information thereof to k2-bit data and the reliability information of the data.

The interleaver 231 re-arranges a signal S230 including the converted k2-bit data and the reliability information of the data according to the same rule as in the interleaver 207 to obtain a sequence signal S232 formed of k2-bit data and the reliability information of the data.

The second re-coder 233 uses the signal S232 formed of the k2-bit data and the n2-bit reliability information of the data to perform re coding of CC2, obtains n2 bit coded data, and generates the reliability information of the coded data by the use of the reliability information included in the signal S232. A signal S244 indicates k2-bit coded data and the n2-bit reliability information thereof.

When the first decoder 219 and the second decoder 225 which apply soft-decision decoding to the convolutional codes CC2 and CC1 and output the decoding results and the reliability information of the outputs, are configured with the use of the Viterbi algorithm or the soft-output Viterbi algorithm, if the reliability information is expressed in logarithm, the first re-coder 227 and the second re-coder 233 can have a circuit structure shown in Fig. 11.

A re-coder shown in Fig. 11 includes a first re-coding circuit formed of a first unit-delay circuit 251 and a first exclusive-OR circuit 252, and a second re-coding circuit formed of a second unit-delay circuit 261 and an arithmetic adding circuit 262.

The first re-coding circuit receives, for example, the k1-bit CC1 decoding result output from the second decoder 225 in units of bits as input data S250. A first output signal S253 is a one-bit signal which is the same as the input data S250, and a second output signal S254 is coded data obtained by delaying the one-bit input data S250 by a time unit and applying exclusive OR with the next input data.

The second re-coding circuit receives, for example, the n1-bit reliability information output from the second decoder 225 in units of bits as input data S260. A first output signal S263 is the same as one-bit input data S260, and a second output signal S264 is coded data obtained by adding the one-bit input data S260 of the reliability information delayed by a time unit to the next input data.

The operation of the entire data transfer system shown in Fig. 9 will be described below.

In the transmission apparatus 1E, the convolutional-code coder 203 and the second convolutional-code coder 209 in the circuit structure shown in Fig. 10 apply, for example, concatenated convolutional coding to data. Note, as shown in Fig. 10, the first convolution coder 203 and the second convolution coder 209 are configured so as to output the output signal S234 which is the value as is the input bits, namely the systematic component, the data sent to the channel 213 is the systematic coded data.

The operation of the receiving apparatus will be described when the iteration processing is apllied. The receiving apparatus 2E receives the systematic-code coded data transferred through the channel 213 and applies processing to received data S214 in units of predetermined-sequence-length data. The selector 217 first selects the received data S214 according to a selection signal SEL sent from the control circuit, and the first decoder 219 applies soft decision decoding to CC2.

The CC2 decoding result S220 corresponding to one bit and obtained by the first decoder 219 is de-interleaved by the de-interleaver 221 and is converted to a bit signal corresponding to two bits and suited to the second decoder 225, by the serial-parallel converter 223.

The second decoder 225 also applies soft-decision decoding to CC1.

The signal S226, which includes the decoding data and the reliability information output from the second decoder 225 is input, for example, to the first re-coder 227 having the structure shown in Fig. 11 and is re-coded. The result is converted by the parallel-serial converter 229 and is interleaved by the interleaver 231. The interleaved result S232 is re-coded, for example, by the second re-coder 233 having the structure shown in Fig. 11.

The selector 217 selects the re-coded data and reliability information S244 output from the second re-coder 233 according to the control circuit, and outputs it to the first decoder 219. The first decoder 219 to the second decoder 225 perform the above-described operations. With these operations, a second decoding result S226 is obtained.

The processing is repeated the required number of times, the resultant decoded result S226 is converted into eight bit data by the serial/parallel converter 235 to obtain the final transport stream (TS) reproduction data S236.

The third embodiment has an advantage that a decoding result having a different error-correcting capability is obtained with the same circuit structure by controlling the number of times the decoding processing is repeated.

The number of times the processing is repeated is determined by the form, the required error immunity, and the reliability information of a decoding result of the receiving apparatus 2E. In a receiving apparatus 2E used for a case in which simple receiving is sufficient, a decoding result is obtained after the processing is repeated a smaller number of times. Therefore, a error-correcting capability is low, but the decoding result is obtained within a short period. When a high error immunity is required, a higher-reliability decoding result is obtained by increasing the number of times the processing is repeated. However, the decoding result is not obtained within a short period of time.

With a threshold determination circuit not shown being provided, repetitive decoding processing can be finished when the reliability of a decoding result exceeds a predetermine threshold.

Next, more simple decoding in which the iteration processing is not performed will be described. The transfer data is systematic code coded by the transmission apparatus as described above. Therefore, one method for performing the simple decoding is that the first decoder 219 performs a hard-decision the received data which is not coded bits among the received data, namely, corresponds to the systematic component to quickly result in the decoded result. Another method is that the second decoder 225 performs the simple decoding same as in the first decoder 219 mentioned above to result in the decoded result. Further, other method is that the decoded result is obtained by the signal S226 corresponding to one bit and the reliable information. In the simple decoding, the decoded result is converted into eight bit data by the serial/parallel converter 235 to obtain the transport stream (TS) reproduction data S236.

The receiving apparatus required the only simple reception performs only the above mentioned simple decoding or is configured to obtain the decoded result by small iteration processing.

Fourth embodiment

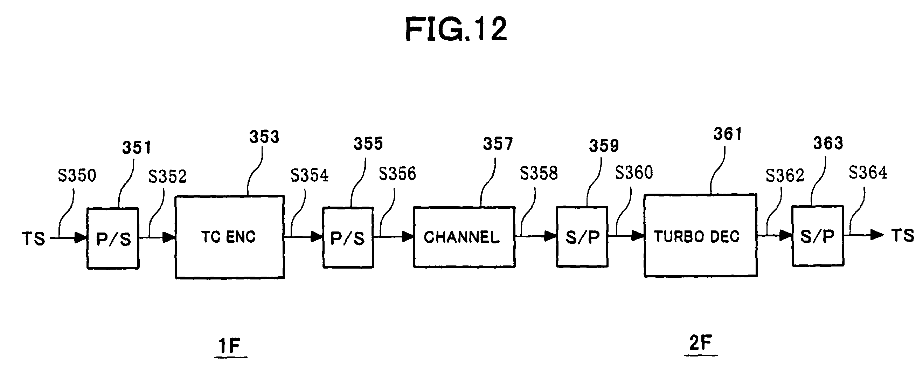

A fourth embodiment of the present invention in which turbo-code coding and simplified decoding processing, will be described below by referring to Fig. 12.

Figure 12 is a structural view of a data transfer system according to the fourth embodiment, which receives a transport stream (TS) and applies turbo-code (coding rate R = 1/3) coding and simplified decoding processing.

The data transfer system includes a transmission apparatus 1F, a channel 357, and a receiving apparatus 2F.

The transmission apparatus 1F has a first parallel-serial converter 351, a turbo-code coder 353, and a second parallel-serial converter 355.

The receiving apparatus 2F has a first serial-parallel converter 359, a turbo decoder 361, and a second serial parallel converter 363.

In the transmission apparatus 1F, the parallel-serial converter 351 converts an eight-bit transport stream (TS) to one-bit serial data.

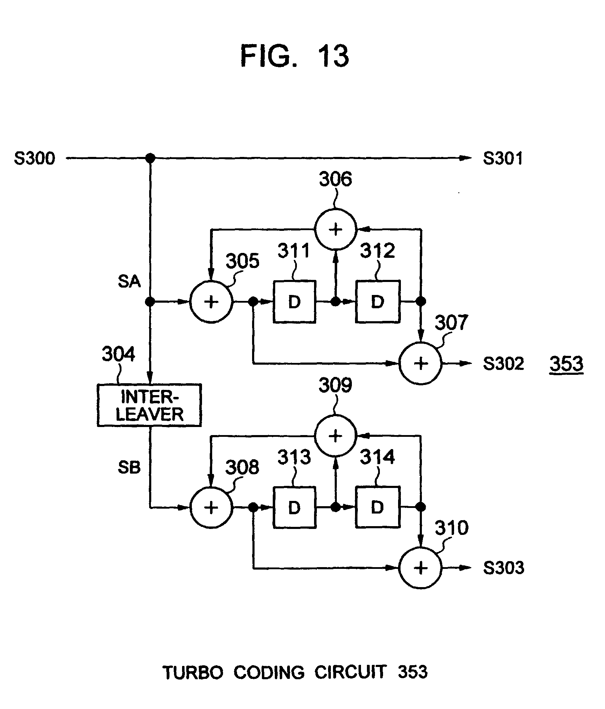

The turbo-code coder 353 applies turbo-code coding to the one-bit serial data, for example, by a turbo-code coding circuit shown in Fig. 13.

The turbo-code coding circuit shown in Fig. 13 is an example circuit for coding a turbo code (coding rate R = 1/3). The turbo-code coding circuit is provided with, an interleaver 304, and first and second convolution coding circuits having the same circuit structure and positioned both sides of the interleaver 304. A symbol "D" indicates a one-bit unit-delay circuit, and an encircled plus sign indicates a one-bit arithmetic adding circuit.

The operation of the turbo-code coder will be described below.

A one-bit serial data S300 output from the parallel-serial converter 351 is output as is as a first output signal S301. In other words, the first output signal S301 is identical with the original input signal.

The first convolution coding circuit formed of arithmetic adding circuits 305, 306, and 307 and unit-delay circuits 311 and 312 outputs a second output signal S302.

The interleaver 304 re-arranges the order of the one-bit serial input sequence according to a predetermined rule and outputs a one-bit serial output sequence.

The second convolution coding circuit formed of arithmetic adding circuits 308, 309, and 310 and unit-delay circuits 313 and 314 applies a second-circuit calculation to a signal obtained by interleaving the input signal S300 and outputs a third output signal S303.

It is deemed that such the turbo coder 353 is configured by a first systematic convolution coder which obtains the output signal S301 and the output signal S302 from the input data S300, and a second systematic convolution coder which obtains the output signal S301 and the output signal S303 from the input data.

A signal S354 output from the turbo-code coder 353 performing the above operation is a turbo-code coded three-bit data.

The second parallel-serial converter 355 converts three-bit data to one bit data. A signal S356 is converted data and sent to the channel 357.

The channel 357 includes a channel coding apparatus, an actual channel, and a channel decoding apparatus. An error may be added to transfer data due to noise in a transfer process.

Data transferred through the channel 357 is received by the receiving apparatus 2F. One-bit data is converted to three-bit data by the first serial-parallel converter 359.

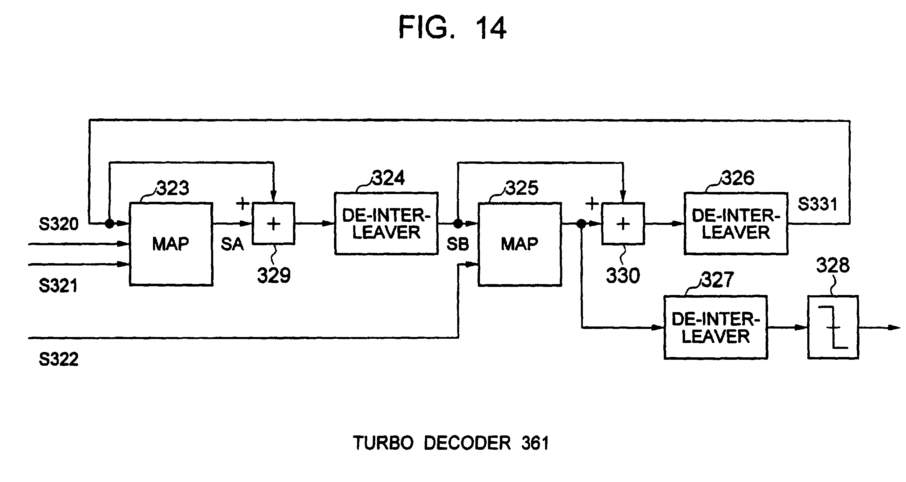

The turbo decoder 361 performs the decoding of the converted data S360. Figure 14 shows an example circuit of the turbo decoder 361.

This turbo decoder is formed of a first MAP (maximum a posteriori probability) decoder 323, an adding circuit 329, an interleaver 324, a second MAP decoder 325, a subtracting circuit 330, a first de-interleaver 326, a second de-interleaver 327, and a threshold determination circuit 328.

Input signals S320, S321, S322 are received data corresponding to the outputs S301, S302, and S303 of the coder shown in Fig. 13.

The interleaver 324 re-arranges the order of a one-bit input sequence according to the same rule as that used in the interleaver 304 (Fig. 13) of the turbo-code coder 353 in the transmission apparatus 1F to obtain a one-bit output sequence. Each of the first de-interleaver 326 and the second de-interleaver 327 re-arranges the order of a one bit serial input sequence according to the rule reverse to that used in the interleaver 304 (Fig. 13) of the turbo-code coder 353. The threshold determination circuit 328 determines whether the output of the second de-interleaver 327 exceeds a threshold.

The operation of the entire turbo decoder will be described below. An output signal S331 of the de-interleaver 326 indicates the reliability information, and its value is set to 0 at the start of the decoding. The MAP decoder 323 performs a maximum a posteriori probability decoding by using the received data S320 and S321 corresponding to the outputs S301 and S302 of the coder, to obtain the decoded result and the reliability information. The adding circuit 329 adds the decoded result of the MAP decoder 323 and the reliability information S331 of the de-interleaver 326. The interleaver 324 performs the interleaving processing to an adding result to obtain the reliability information of the data corresponding to the output SB of the interleaver 304 of the turbo-code coder 353. It corresponds to the input data of the adding circuit 308. With the use of the received data S322 corresponding to the code output S303 of the turbo-code coder 353, the second MAP decoder 325 performs the decoding corresponding to the coding performed by the second coding circuit.

In simple decoding, the second de-interleaver 327 processes the decoding result obtained at this point and the threshold determination circuit 328 applies determination by the predetermined threshold to obtain a decoding result corresponding to coding performed by the turbo-code coder 353.

Decoding with a higher error-correcting capability will be described below.

The subtracting circuit 330 calculates a difference between the decoding result output from the second MAP decoder 325 and the output of the interleaver 324, that is, an increase of reliability information, and the first de-interleaver 326 obtains reliability information S331 corresponding to the input data SA of the adding circuit 305 in the first circuit constituting the turbo-code coder 353.

Then, the processing is iterated in the foregoing order. Specifically, with the use of the received data outputs S320 and S321 corresponding to the coder outputs S301 and S302, and the reliability information obtained by the second MAP decoder 325, the first MAP decoder 323 obtains the reliability information. In the iterated processing, the output of the adding circuit 329 corresponds to an increase of the output of the first MAP decoder 323 against the input of the first MAP decoder 323.

The processing is iterated a predetermined number of times in the foregoing order to obtain output data. The predetermined number of times is determined from the form of the receiver, a required error immunity (tolerance), and the reliability information of the decoding result. In other words, in a receiver for which simple receiving is required, a decoding result is obtained after the processing iterated a smaller number of times. When a high error immunity is requested, it is expected that a higher-reliability decoding result is obtained with the processing iterated a larger number of times. With the threshold determination circuit 328, processing for finishing repetitive decoding processing when the reliability of the decoding result exceeds a predetermined threshold can be performed.

The second serial-parallel converter 363 converts a one-bit serial decoding result S362 to eight-bit parallel data. As a result, a reproduced transport stream (TS) S364 is obtained.

Also in the fourth embodiment, the receiving apparatus 2F can specify an error-correcting capability with one circuit by determining the number of times the processing of the circuit in the turbo decoder 361 shown in Fig. 14 is repeated. Therefore desired error correcting processing is adaptively performed with one circuit structure. Also, the receiving apparatus which is required the only simple reception of the signal, performs only the above simple decoding, or can be configured to perform small number of iteration processing and to thereby obtain the decoded result. On the other hand, the receiving apparatus which is always required a high tolerance to an error, can be desired to obtain a high reliable decoded result by increasing the number of the iteration processing.

Fifth embodiment

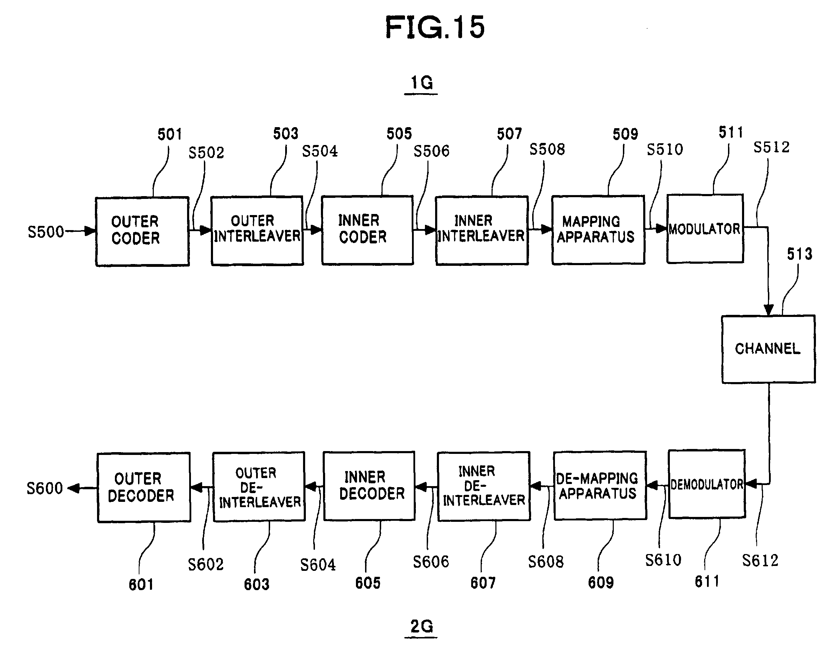

A digital-data transfer system using an inner code, an outer code, an interleaver, and a digital modulation method according to a fifth embodiment of the present invention will be described below by referring to Fig. 15.

Figure 15 is a structural view of the data transfer system according to the fifth embodiment.

This digital-data transfer system has a transmission apparatus 1G, a channel 513, and a receiving apparatus 2G.

The transmission apparatus (transmitter) 1 includes an outer-code coder 501, an outer interleaver 503, an inner-code coder 505, an inner interleaver 507, a mapping unit 509, and a modulator 511.

The channel 513 is a channel such as an antenna or a transmission wire.

The receiving apparatus 2G includes a demodulator 611, a de-mapping unit 609, an inner de-interleaver 607, an inner-code decoder 605, an outer de-interleaver 603, and an outer-code decoder 601.

The operation of the data transfer system shown in Fig. 15 will be described below.

In the transmission apparatus 1G, the outer-code coder 501 converts the data S500 input to the same to a form suited to coding in terms of a data format such as the number of bits in input data. Outer-code coding is then applied according to the above-described outer-code coding method, and is sent to the outer interleaver 503 as coded data S502.

The outer interleaver 503 converts the input data S502 to have a data format, such as the number of bits, suited to the input data, the interleaver, or output data, applies outer interleaving according to an outer interleaving method, and outputs outer-interleaved data S504.

The inner-code coder 505 converts the input data 504 to have a data format, such as the number of bits, suited to coding, applies inner-code coding according to an inner-code coding method, and outputs coded data S506 to the inner interleaver 507.

The inner interleaver 507 converts the input data S506 to have a data format, such as the number of bits, suited to the input data, the interleaver, or output data, applies inner interleaving according to an inner interleaving method, and outputs inner-interleaved data S508 to the mapping unit 509.

The mapping unit 509 converts the number of bits in the input data S508 to that used as a modulation unit for carrier modulation to be performed in the modulator 511, and applies calculation or conversion to data used for modulation in the modulator 511 according to the converted data having the number of bits used as the modulation unit to obtain modulation data S510.

The modulator 511 performs carrier modulation according to the modulation data S510, performs frequency conversion to a frequency suited to transfer, performs power amplification to an electric power suited to channel 513.

The transmission apparatus 1G uses an outer code and/or an inner code for which an error characteristic can be controlled according to the amount of processing at a receiving side. The receiving side can simplify decoding of each code according to the form of receiving and a required error characteristic. A specific example will be described below.

An MPEG-2 transport stream (TS) is used as the input data S500, and a product code C1 x C2 of the Reed-Solomon code, RS (204, 188), described above by referring to Fig. 3 is used as an outer code. In this case, the interleaving shown in the third embodiment is not performed between coding performed in a C1 direction arid that performed in a C2 direction in the processing of the product code C1 x C2.

The outer interleaver 503 then performs coding; and applies the block interleaving or the convolutional interleaving shown in the second embodiment in units of packets to which a parity is added, or does not apply interleaving in units of packets. Or, such the interleaving in the packet unit can be omitted. Then, the outer-code interleaver 503 perform the block interleaving or convolutional interleaving in units of bytes constituting a packet to obtain a result S504 of outer interleaving.

As an inner code, the convolutional code, the punctured code, or the turbo code described in the above embodiments, or a trellis code used for coding modulation which uses the foregoing code as a basic code is used.

The inner-code coder 505 bit-converts data input in units of bytes to one-bit data or data having the number of bits required for the coder, and applies coding. When the convolutional code the punctured code, or the turbo code is used, coded data is parallel-serial converted to output one-bit data for convenience at subsequent stages. Alternatively, data is output with the number of bits of data coded by the trellis code used for coding modulation which uses the convolutional code, the punctured code, or the turbo code as a basic code.

Then, the inner interleaver 507 performs interleaving suited to a modulation method to be performed by the modulator 511.

When the convolutional code, the punctured code, or the turbo code is used as an inner code in the inner-code coder 505, and QPSK modulation using one carrier is used as the modulation method in the modulator 511, data to be modulated has two bits. The order of a one bit input bit sequence is changed in units of blocks or by a convolutional-type interleaver to obtain a one-bit output sequence. Alternatively, this interleaving may be omitted.

The sequence is converted to two-bit parallel data by serial-parallel conversion for QPSK modulation in the modulator 511.

Bit interleaving is applied to the two-bit data sequence by a convolutional interleaver which uses a bit direction in the inner interleaver 507 as the depth of interleaving. Alternatively, bit interleaving may be omitted. Symbol interleaving is then applied to the two-bit bit-interleaved sequence as a two-bit sequence by a block interleaver or a convolutional interleaver. Alternatively, symbol interleaving may be omitted.

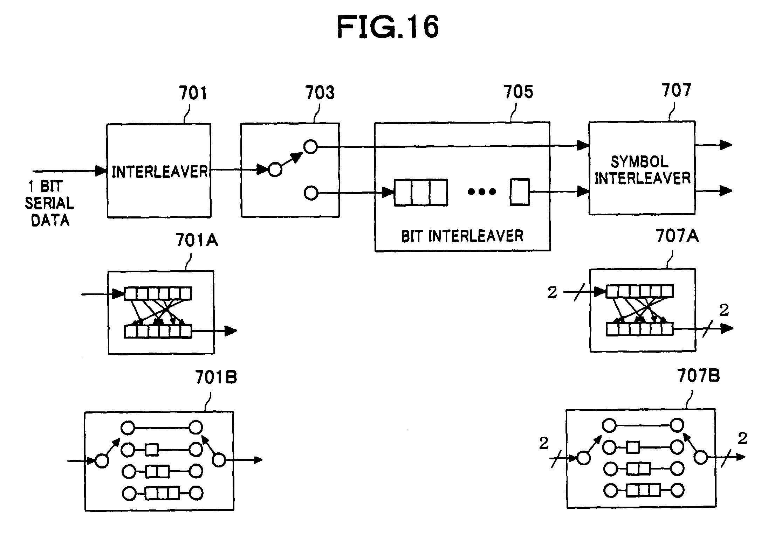

Figure 16 shows an example structure of the above described inner interleaver 507.

The inner interleaver 507 shown in Fig. 16 includes an interleaver 701, a serial-parallel converter 703, a bit interleaver 705, and a symbol interleaver 707.

The interleaver 701 can have a structure such as that of a first-form interleaver 701A or that of a second-form interleaver 701B according to the above-described various forms.

In the same way, the symbol interleaver 707 can have a structure such as that of a first-form symbol interleaver 707A or that of a second form symbol interleaver 707B according to the above-described various forms.

When the convolutional code, the punctured code, or the turbo code is used; an OFDM modulation method using a plurality of carriers is used as a modulation method; and QPSK modulation is performed for each carrier user for the OFDM modulation method, data for each-carrier modulation has two bits and forms an OFDM frame for performing OFDM modulation. Therefore, bit interleaving is performed as in the bit interleaver 705, shown in Fig. 16, of the inner interleaver 507 used for the above case in which a single carrier is used, and then interleaving is performed in units of OFDM frames by a block interleaver or a convolutional interleaver. Alternatively, this interleaving is not performed. Then, symbol interleaving is performed within an OFDM frame and an interleaving result is output.

When the convolutional code, the punctured code, or the turbo code is used as a basic code, and inner interleaving is applied to data coded by a trellis code and used for coding modulation in which a single carrier is 8PSK-modulated by the use of coded data, symbol interleaving is applied to an input of the inner interleaver 507 as a three-bit sequence as is by a block interleaver or a convolutional interleaver.

When the convolutional code, the punctured code, or the turbo code is used as a basic code; OFDM modulation is performed by the use of coded data; and inner interleaving is applied to data coded by a trellis code and used for coding modulation in which each carrier constituting the OFDM modulation method, interleaving is performed in units of OFDM frames by a block interleaver or a convolutional interleaver. Alternatively, interleaving is not performed. Then, symbol interleaving is performed within an OFDM frame to output an interleaving result.

When the modulator 511 modulates a single or a plurality of carriers by QPSK or 8PSK, the mapping unit 509 assigns two-bit or three-bit input data S508 to a modulation point in a signal-point coordinate system and outputs data S510 indicating a modulation point to the modulator 511.

The modulator 511 modulates a single or a plurality of carriers by the use of the input data S510 and performs precessing for sending the above-described transmission signal.

The receiving apparatus 2G performs the operation reverse to that performed by the transmission apparatus 1G.

The receiving apparatus 2G can simplify decoding of each code according to the form of receiving and a required error characteristic in the receiving apparatus 2G as described in the above embodiments, and can simplify decoding as described in other embodiments in decoding of an inner code and decoding of an outer code.

In the above various embodiments, a video signal and/or an audio signal for TV broadcasting are used as examples of digital data to be transferred, and the transport stream format is assumed. It is obvious from the descriptions of the above embodiments that the present invention is limited neither to a case in which a video signal and/or an audio signal are used nor to a case in which the transport stream format is employed.

As a processing method of digital transfer data in a transmission apparatus and a receiving apparatus of the present embodiment, the following various methods can be used. (1) Digital transfer data is divided into frames; and error-correcting processing and error-correcting processing is performed in units of frames. (2) Digital transfer data is divided into frames as sets of fixed-length or valuable-length packets; and error-correcting processing is performed in units of packets. (3) Digital transfer data is divided into frames as sets of fixed-length or variable-length packets, error-control is performed in units of packets, and error-control processing is applied in units of frames which are sets of packets to which error correcting has been applied.

Various types of digital transfer data can be processed. A video signal and/or an audio signal are appropriate example transfer data.

When the transmission apparatus 1 sends a digital video signal and a digital audio signal at the same time, it applies multiplexing and the receiving apparatus 2 releases multiplexing (applies de-multiplexing) and processes the digital video signal and the digital audio signal separately.

It is preferred that the above digital video signal and digital audio signal be compression-coded, for example, by the MPEG (Moving Picture coding Expert Group) method. The above error-correcting processing can be applied to a digital video signal and a digital audio signal having such a form in units of transfer stream packets (TSPs). A one-frame transport streams (TS) is formed of a plurality of transport stream packets (TSPs). One transport streams (TS) may include the fixed number or variable number of transport stream packets (TSPs).

In the above-described embodiments, various example circuit structures have been described. The present invention is not limited to those embodiments. Various modifications and other correction can be made in the scope of the technical aspect of the present invention.

A transmission apparatus and a receiving apparatus according to the embodiments of the present invention can perform digital modulation and digital demodulation in various methods. As digital modulation, for example, a PSK (phase shift keying) method, an FSK (frequency shift keying) method, an ASK (amplitude shift keying) method, a QAM (quadrature amplitude modulation) method, an OFDM (orthogonal frequency division multiplexing) method, or a CDM (code division multiplexing) method can be used. Digital demodulation corresponding to a modulation method used is performed.

It is preferred that the receiving apparatus apply synchronous reproduction and digital demodulation, if necessary.

According to the present invention, a single channel coded data can be transferred by a transmission apparatus a receiving apparatus is allowed to perform appropriate error-correcting processing and decoding processing according to situations (conditions) such as the processing capability, the use, and the operation condition of the receiving apparatus. Especially in the first embodiment of the present invention, a desired level of error-correcting processing and decoding processing can be implemented by the number of iterations with the same circuit structure. In addition, a receiving apparatus of the present invention can implement simple decoding processing not depending on error-correcting processing and coding performed by a transmission apparatus.

According to the present invention, a transmission apparatus which effectively cooperates with the above-described receiving apparatus is provided.

According to the present invention, a data transfer system which can appropriately handle an error added in a channel is provided by a combination of the above-described transmission apparatus and the above-described receiving apparatus.

According to the present invention, a data receiving method by which the above-described receiving apparatus performs receiving processing, a data transmission method by which the above-described transmission apparatus performs transmission processing, and a data transfer system in which these are combined are provided.

INDUSTRIAL APPLICABILITY

The present invention can be applied to various data transfer systems.

LIST OF REFERENCE NUMERALS

| | |
|---|---|
| 1 | Transmission Apparatus |
| 11 | Error Correction Coding Means |
| 2 | Receiving Apparatus |
| 20 | Decoding Means |
| 21 | First Decoding Means |

| | |
|---|---|
| 22 | Second Decoding Means |
| 3 | Channel means |
| 101 | Read-Solomon (204, 188) Coder |
| 105 | Simple Decoder |
| 107 | Regular Decoder |
| 121 | First Read-Solomon Coding Unit |
| 123 | Interleaver |
| 125 | Second Read-Solomon Coding Unit |
| 129 | First Simple Decoder |
| 131 | De-interleaver |
| 133 | Second Simple Decoder |
| 135 | Second Read-Solomon Decoding Section |
| 137 | De-interleaver |
| 139 | Simple Decoder |
| 141 | First Read-Solomon Decoding Section |
| 143 | De-interleaver |
| 145 | Second Read-Solomon Decoding Section |
| 147 | Product-code Decoding Unit |
| 203 | First Convolutional-code Coder |
| 207 | Interleaver |
| 209 | Second Convolutional-code Coder |
| 217 | Selector |
| 219 | First Decoder |
| 221 | De-interleaver |
| 225 | Second Decoder |
| 227 | First Re-coder |
| 231 | Interleaver |
| 233 | Second Re-coder |
| 353 | Turbo-code Coder |
| 361 | Mapping Decoder |
| 501 | Outer Coder |
| 503 | Outer Interleaver |
| 505 | Inner Coder |
| 507 | Inner Interleaver |
| 509 | Mapping apparatus |
| 511 | Modulator |
| 611 | Demodulator |
| 609 | De-mapping Apparatus |
| 607 | Inner De-interleaver |
| 605 | Inner Decoder |
| 603 | Outer De-interleaver |
| 601 | Outer Decoder |

**Claims**

1. A data transfer system comprising:

a transmission apparatus including an coding means for performing a channel coding to a digital transfer data by using one step or a plurality of steps of error correction code(s) which is (are) obtained a first error characteristic when the digital transfer data is performed a channel decoding of a first decoding method at a receiving side;
a channel means for transferring the channel coded data sent from said transmission apparatus; and
a receiving apparatus including a decoding means for receiving the channel coded data transferred through the channel means, and performing a channel decoding the received channel coded data by using a second decoding method having an error characteristic lower than that of the first decoding method.

2. A data transfer system according to claim 1, wherein said receiving apparatus comprises a second decoding means for performing a channel decoding of the first decoding method.

**3.** A data transfer system according to claim 1, wherein at least one steps of said error correction code, and
    wherein said decoding means performs the decoking by using only systematic component of said systematic code.

**4.** A data transfer system according to claim 1, wherein at least one step of said error correction codes comprises a product code, and
    wherein said decoding means performs the error correction by using only one side parity of said product code.

**5.** A data transfer system according to claim 1, wherein said error correction code comprises an error correction code which can control the error characteristic, and
    wherein said decoding means performs the decoding the data at amount of precessing lower than that of said first decoding method.

**6.** A data transfer system according to claim 5, wherein at least one step of said error correction codes comprises an error correction code which can correct an erasure, and
    wherein said decoding means performs the decoding the data without erasure correction.

**7.** A data transfer system according to claim 5, wherein at least one step of said error correction codes comprises an error correction code enabling an iteration decoding, and
    wherein said decoding means does not perform the iteration decoding or performs the iteration decoding at an iteration number smaller than that of the first decoding method.

**8.** A data transfer system according to claim 7, wherein said error correction code enabling the iteration decoding comprises a concatenated code of a convolution code.

**9.** A data transfer system according to claim 7, wherein said error correction code enabling the iteration decoding comprises a turbo code.

**10.** A data transfer system according to claim 7, wherein the error correction code enabling the iteration decoding comprises a product code.

**11.** A data transfer method including:

    an coding step for performing a channel coding to a digital transfer data by using one step or a plurality of steps of error correction code(s) which is (are) obtained a first error characteristic when the digital transfer data is performed a channel decoding of a first decoding method at a receiving side;
    a transmission step for transmitting the channel coded data produced at transmission step;
    a receiving step for receiving the channel coded data; and
    a decoding step for performing a channel decoding the received channel coded data by using a second decoding method having an error characteristic lower than that of the first decoding method.

**12.** A data transfer method according to claim 11, including a second decoding step for performing a channel decoding of the first decoding method.

**13.** A data transfer method according to claim 11, wherein at least one steps of said error correction code, and
    wherein in said decoding step the decoding is performed by using only systematic component of said systematic code.

**14.** A data transfer method according to claim 1, wherein at least one step of said error correction codes comprises a product code, and
    wherein in said decoding step the error correction is performed by using only one side parity of said product code.

**15.** A data transfer method according to claim 11, wherein said error correction code comprises an error correction code which can control the error characteristic, and
    wherein in said decoding step the decoding the data is performed at amount of processing lower than that of said first decoding method.

**16.** A data transfer method according to claim 15, wherein at least one step of said error correction codes comprises an error correction code which can correct an erasure, and

wherein in said decoding step the decoding the data is performed without erasure correction.

**17.** A data transfer method according to claim 15, wherein at least one step of said error correction codes comprises an error correction code enabling an iteration decoding, and

wherein in said decoding step the iteration decoding is not performed or the iteration decoding is performed at an iteration number smaller than that of the first decoding method.

**18.** A data transfer method according to claim 17, wherein said error correction code enabling the iteration decoding comprises a concatenated code of a convolution code.

**19.** A data transfer method according to claim 17, wherein said error correction code enabling the iteration decoding comprises a turbo code.

**20.** A data transfer method according to claim 17, wherein the error correction code enabling the iteration decoding comprises a product code.

**21.** A data receiving apparatus receiving a channel coded data which is produced by performing a channel coding to a digital transfer data by using one step or a plurality of steps of error correction code(s) which is (are) obtained a first error characteristic when the digital transfer data is performed a channel decoding of a first decoding method at a receiving side, said data receiving apparatus comprises:

a decoding means for performing a channel decoding the channel encoded data by using a second decoding method having an error characteristic lower than that of the first decoding method.

**22.** A data receiving apparatus according to claim 21, wherein said receiving apparatus comprises a second decoding means for performing a channel decoding of the first decoding method.

**23.** A data receiving apparatus according to claim 21, wherein at least one steps of said error correction code, and

wherein said decoding means performs the decoking by using only systematic component of said systematic code.

**24.** A data receiving apparatus according to claim 21, wherein at least one step of said error correction codes comprises a product code, and

wherein said decoding means performs the error correction by using only one side parity of said product code.

**25.** A data receiving apparatus according to claim 21, wherein said error correction code comprises an error correction code which can control the error characteristic, and

wherein said decoding means performs the decoding the data at amount of precessing lower than that of said first decoding method.

**26.** A data receiving apparatus according to claim 25, wherein at least one step of said error correction codes comprises an error correction code which can correct an erasure, and

wherein said decoding means performs the decoding the data without erasure correction.

**27.** A data receiving apparatus according to claim 25, wherein at least one step of said error correction codes comprises an error correction code enabling an iteration decoding, and

wherein said decoding means does not perform the iteration decoding or performs the iteration decoding at an iteration number smaller than that of the first decoding method.

**28.** A data receiving apparatus according to claim 27, wherein said error correction code enabling the iteration decoding comprises a concatenated code of a convolution code.

**29.** A data receiving apparatus according to claim 27, wherein said error correction code enabling the iteration decoding comprises a turbo code.

**30.** A data receiving apparatus according to claim 27, wherein the error correction code enabling the iteration decoding comprises a product code.

# FIG.1

EP 1 083 660 A1

# FIG.2

ERROR CORRECTION CODING MEANS — 11

TRANSMISSION APPARATUS — 1

CHANNEL MEANS — 3

DECODING MEANS PERFORMING DECODING IN RESPONSE TO LEVELS OF ERROR CORRECTION PROCESSING AND DECODING PROCESSING — 20

RECEIVING APPARATUS — 2

EP 1 083 660 A1

# FIG. 3

RS (204, 188) CODING METHOD

EP 1 083 660 A1

# FIG. 4

1C                                     2C

TSP →[S100] **101** RSE [S102]→ **103** CHANNEL [S104]→ **105** SIMPL DECODER [S106]→

**107** RSD [S108]→

TRANSFER SYSTEM OF FIRST EMBODIMENT

# FIG. 5

## 105

S104 ——————————→ **111** → S112(S106) →

**113** COUNTER [S114]→ **115** → [S116]

REFERENCE SIGNAL REF

$(0 <= cnt <= 187)$

SIMPLE DECODER

# FIG.6

RS(204,188) PRODUCT CODING PROCESSING

# FIG. 7

## FIG. 8A CODED TSP INTERLEAVER

| | | | |
|---|---|---|---|
| 1 | 2 | 3 | 4 |
| 5 | 6 | 7 | 8 |
| 9 | 10 | 11 | 12 |
| 13 | 14 | 15 | 16 |

## FIG. 8B WHEN NOT INTERLEAVE

| t=t1 | t=t2 |
|---|---|
| 1 | 189 |
| 2 | 190 |
| 3 | 191 |
| 4 | 192 |
| ⋮ | ⋮ |
| 188 | 376 |

## FIG. 8C WHEN INTERLEAVED

| t=t1 | t=t2 |
|---|---|
| 1 | 180 |
| 5 | 184 |
| 9 | 188 |
| 13 | 192 |
| ⋮ | ⋮ |
| 191 | 383 |

## FIG. 8D CONVOLUTED TSP INTERLEAVE

SW1

S150 → 154 → 13 → S164

S151 → 155 → 14 → 158 → 10 → S165

S168

S152 → 156 → 15 → 159 → 11 → 161 → 7 → S166

S153 → 157 → 16 → 160 → 12 → 162 → 8 → 163 → 4 → S167

SW2

S169

## FIG. 8E CONVOLUTED INTERLEAVE PROCESSING

| t=t1 | t=t2 |
|---|---|
| 1 | 189 |
| -2 | 186 |
| -5 | 183 |
| -8 | 180 |
| ⋮ | ⋮ |
| 176 | 364 |

FIG. 9

DATA TRANSFER SYSTEM OF THIRD EMBODIMENT

2E

FIG. 10

FIG. 11A

FIG. 11B

# FIG.12

# FIG. 13

TURBO CODING CIRCUIT 353

# FIG. 14

TURBO DECODER 361

EP 1 083 660 A1

# FIG.15

## 1G

S500 → **OUTER CODER** (501) →S502→ **OUTER INTERLEAVER** (503) →S504→ **INNER CODER** (505) →S506→ **INNER INTERLEAVER** (507) →S508→ **MAPPING APPARATUS** (509) →S510→ **MODULATOR** (511) →S512→

**CHANNEL** (513)

S600 ← **OUTER DECODER** (601) ←S602← **OUTER DE-INTERLEAVER** (603) ←S604← **INNER DECODER** (605) ←S606← **INNER DE-INTERLEAVER** (607) ←S608← **DE-MAPPING APPARATUS** (609) ←S610← **DEMODULATOR** (611) ←S612←

## 2G

EP 1 083 660 A1

FIG.16

# FIG.17

1A : TRANSMISSION APPARATUS

2A : RECEIVING APPARATUS

EP 1 083 660 A1

FIG. 18

TSP

TRANSPORT STREAM PACKET
TSP OF 188 BYTES

TS HEADER OF 4 BYTES

| 0x47 | PID.TEI | PAYLOAD |

SYNCHRONOUS BYTE

EP 1 083 660 A1

## FIG. 19A TRANSMISSION APPARATUS:1B

## FIG. 19B RECEIVING APPARATUS:2B

# FIG.20

# INTERNATIONAL SEARCH REPORT

| International application No. |
|---|
| PCT/JP00/00709 |

**A. CLASSIFICATION OF SUBJECT MATTER**
Int.Cl⁷  H03M13/35

According to International Patent Classification (IPC) or to both national classification and IPC

**B. FIELDS SEARCHED**

Minimum documentation searched (classification system followed by classification symbols)
Int.Cl⁷  H03M13/35

Documentation searched other than minimum documentation to the extent that such documents are included in the fields searched
Jitsuyo Shinan Koho(Y1,Y2)    1926-2000   Toroku Jitsuyo Shinan Koho(U) 1994-2000
Kokai Jitsuyo Shinan Koho(U)   1971-2000   Jitsuyo Shinan Toroku Koho(Y2)1996-2000

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP, 61-237523, A (Sony Corporation), 22 October, 1986 (22.10.86), Fig. 5 (Family: none) | 1-30 |
| A | JP, 02-039627, A (NIPPON HOSO KYOKAI), 08 February, 1990 (08.02.90), Fig. 2 (Family: none) | 1-30 |
| A | Motohiko Izaka, et al, "Shannon genkai eno douhyo: "Parallel concatenated (Turbo) coding", "Turbo (iterative) decoding" to sono shuhen", Technical research report, The Institute of Electronics, Information and Communication Engineers, *Shinkaku gihou*, Vol.98, No.441, IT98-51, 1998-12, pp.1-18 | 1-30 |

☐ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 May, 2000 (09.05.00) | 23 May, 2000 (23.05.00) |

| Name and mailing address of the ISA/ | Authorized officer |
|---|---|
| Japanese Patent Office | |
| Facsimile No. | Telephone No. |

Form PCT/ISA/210 (second sheet) (July 1992)